# EUROPEAN PATENT APPLICATION

(11) **EP 3 217 490 A1**
(43) Date of publication of application: **13.09.2017**
(21) Application number: 17160162.8
(22) Date of filing: 09.03.2017
(51) Int. Cl.: H01S 5/024, F02P 23/04

(54) **LASER-BEAM EMITTING DEVICE AND ENGINE SPARK PLUG SYSTEM**

(30) Priority: 10.03.2016 JP 2016046872; 01.02.2017 JP 2017016665
(71) Applicant: Ricoh Company, Ltd., Tokyo 143-8555 (JP)
(72) Inventor: IKEDA, Keisuke, Ohta-ku, Tokyo 143-8555 (JP); ARAI, Nobuyuki, Ohta-ku, Tokyo 143-8555 (JP)
(74) Representative: Watkin, Timothy Lawrence Harvey

(57) **Abstract**

A laser-beam emitting device (10) and an engine spark plug system (40). The laser-beam emitting device (10) includes a laser-beam source unit (21) configured to emit a laser beam, a condenser lens (23) configured to concentrate the laser beam emitted from the laser-beam source unit (21) to a prescribed position, a holding member (14) configured to contact the condenser lens (23) across its entire surface and hold the condenser lens (23), and a cooler (30) applied to the laser-beam source unit (21), the cooler (30) being configured to cool the laser-beam source unit (21). The holding member (14) has a thermal conductivity higher than a thermal conductivity of the condenser lens (23), and contacts the cooler (30) across its entire surface. The engine spark plug system (40) includes the laser-beam emitting device (10), and a spark plug (52) configured to ignite an internal combustion engine (41), using a laser beam output from the laser-beam emitting device (10).

## Description

### BACKGROUND

### Technical Field

Embodiments of the present disclosure relate to a laser-beam emitting device and engine spark plug system.

### Background Art

Laser-beam emitting devices that use a condenser lens to concentrate the high-power laser beams output from a laser-beam source unit have been proposed for use as an engine spark plug system for internal combustion engines (see, for example, JP-2014-192166-A).

Such laser-beam emitting devices generate heat when the laser-beam source unit outputs high-power laser beams, and tend to be installed in high-temperature environments due to the heat produced in an internal combustion engine. However, if the laser-beam source unit gets too hot, there is some concern that the useful life is prematurely shortened and the output power drops. To cope with such a situation, a cooler is used to keep the laser-beam source unit cool, thus preventing a reduction in useful life and output.

However, in the laser-beam emitting devices described above, a condenser lens concentrates the high-power laser beams output from the laser-beam source unit. For this reason, the condenser lens absorbs some of the laser beams as heat energy, and the temperature of the condenser lens tends to increase. As is known in the art, the optical performance of condenser lenses varies with temperature. For this reason, there is some concern that the laser beams cannot be concentrated on a desired position and a desired amount of light cannot be output appropriately.

### SUMMARY

Embodiments of the present disclosure described herein provide a novel laser-beam emitting device and an engine spark plug system. The laser-beam emitting device includes a laser-beam source unit configured to emit a laser beam, a condenser lens configured to concentrate the laser beam emitted from the laser-beam source unit to a prescribed position, a holding member configured to contact the condenser lens across its entire surface and hold the condenser lens, and a cooler applied to the laser-beam source unit, the cooler being configured to cool the laser-beam source unit. The holding member has a thermal conductivity higher than a thermal conductivity of the condenser lens, and contacts the cooler across its entire surface. The engine spark plug system includes the laser-beam emitting device, and a spark plug configured to ignite an internal combustion engine, using a laser beam output from the laser-beam emitting device.

According to one aspect of the present disclosure, even when a condenser lens concentrates high-power laser beams in laser-beam emitting devices, the temperature of the condenser lens can be prevented from increasing.

### BRIEF DESCRIPTION OF THE DRAWINGS

A more complete appreciation of exemplary embodiments and the many attendant advantages thereof will be readily obtained as the same becomes better understood by reference to the following detailed description when considered in connection with the accompanying drawings.
FIG. 1 is a schematic diagram of an engine spark plug system provided with a laser-beam emitting device used for igniting an internal combustion engine, according to a first embodiment of the present disclosure.
FIG. 2 is a schematic diagram of a laser-beam emitting device according to an embodiment of the present disclosure.
FIG. 3 is a cross-sectional view along line I-I of FIG. 2.
FIG. 4 is a schematic diagram illustrating how wires and electrodes are attached to a thermal diffusion board, according to an embodiment of the present disclosure.
FIG. 5 is a schematic diagram of a laser-beam emitting device according to a first alternative embodiment of the present disclosure.
FIG. 6 is a schematic diagram of a laser-beam emitting device according to a second alternative embodiment of the present disclosure.
FIG. 7 is a schematic diagram of a laser-beam emitting device according to a third alternative embodiment of the present disclosure.
FIG. 8 is a schematic diagram of a laser-beam emitting device according to a fourth alternative embodiment of the present disclosure.
FIG. 9 is a schematic diagram of a laser-beam emitting device according to a second embodiment of the present disclosure.
FIG. 10 is a flowchart of temperature control processes (temperature control method) performed by a temperature controller of a laser-beam emitting device, according to a second embodiment of the present disclosure.
FIG. 11 is a schematic diagram of a laser-beam emitting device according to a fifth alternative embodiment of the present disclosure.
FIG. 12 is a schematic diagram of a laser-beam emitting device according to a third embodiment of the present disclosure.
FIG. 13A and FIG. 13B is a flowchart of temperature control processes (temperature control method) performed by a temperature controller of a laser-beam emitting device, according to a third embodiment of the present disclosure.
FIG. 14 is a schematic diagram of a laser-beam emitting device according to a fourth embodiment of the present disclosure.
FIG. 15 is a flowchart of temperature control processes (temperature control method) performed by a temperature controller of a laser-beam emitting device, according to a fourth embodiment of the present disclosure.
FIG. 16 is a schematic diagram of a laser-beam emitting device according to a fifth embodiment of the present disclosure.
FIG. 17 is a flowchart of temperature control processes (temperature control method) performed by a temperature controller of a laser-beam emitting device, according to a fifth embodiment of the present disclosure.
FIG. 18 is a schematic diagram of a laser-beam emitting device according to a sixth embodiment of the present disclosure.
FIG. 19 is a flowchart of temperature control processes (temperature control method) performed by a temperature controller of a laser-beam emitting device, according to a sixth embodiment of the present disclosure.

The accompanying drawings are intended to depict exemplary embodiments of the present disclosure and should not be interpreted to limit the scope thereof. The accompanying drawings are not to be considered as drawn to scale unless explicitly noted.

### DETAILED DESCRIPTION

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

In describing example embodiments shown in the drawings, specific terminology is employed for the sake of clarity. However, the present disclosure is not intended to be limited to the specific terminology so selected and it is to be understood that each specific element includes all technical equivalents that have the same structure, operate in a similar manner, and achieve a similar result.

Hereinafter, a laser-beam emitting device according to an embodiment of the present disclosure, and an engine spark plug system that is provided with the laser-beam emitting device are described with reference to the drawings.

### First Embodiment

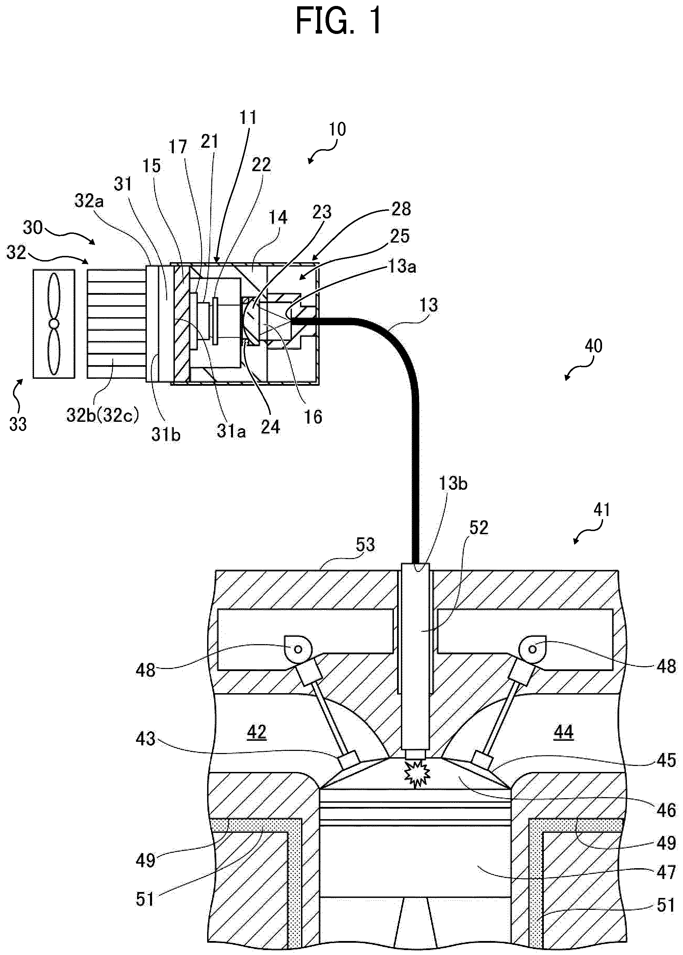

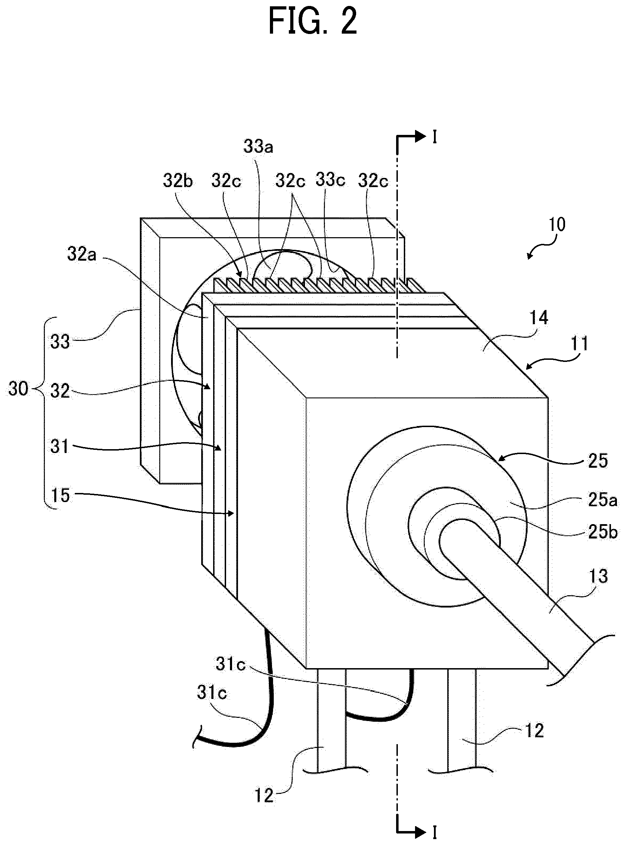

A laser-beam emitting device 10 according to a first embodiment of the present disclosure is described with reference to FIG. 1 to FIG. 4. Together with that, an engine spark plug system 40 that is provided with the laser-beam emitting device 10, according to the first embodiment, is described. For purposes of simplification of the engine spark plug system 40, in FIG. 1, the laser-beam emitting device 10 is illustrated in a simplified manner. For purposes of simplification, an exterior component 28 is omitted from the laser-beam emitting device 10 in FIG. 2. In FIG. 2 to FIG. 4, some components of the laser-beam emitting device 10 are schematically illustrated for purposes of simplification.

As illustrated in FIG. 1, the laser-beam emitting device 10 according to the first embodiment of the present disclosure is a part of the engine spark plug system 40, and is used for igniting an engine 41 that is an example of internal combustion engine. In the engine 41, an air intake valve 43 is provided for an air intake duct 42, and an exhaust valve 45 is provided for an exhaust duct 44. Moreover, a combustion chamber 46 is partitioned by a piston 47 or the like. Each of the air intake valve 43 and the exhaust valve 45 is connected to a cam 48, and the air intake valve 43 and the exhaust valve 45 are moved up and down by these cams 48. Accordingly, the air intake duct 42 or the exhaust duct 44 are opened and closed as desired. The combustion chamber 46 is cooled by cooling water 51 that is supplied to a cooling water channel 49 arranged on the peripheral wall of the combustion chamber 46. In the combustion chamber 46, a spark plug 52 is provided.

The spark plug 52 uses the laser beam emitted from the laser-beam emitting device 10 to perform ignition. The spark plug 52 has good ignition efficiency, and is used for ignition. In the spark plug 52, a laser resonator that includes a Q-switch laser medium is irradiated with the laser beam emitted from the laser-beam emitting device 10, and a giant pulse is oscillated. Further, the spark plug 52 uses an optical element such as a condenser lens to concentrate the pulsed light to the combustion chamber 46 of the engine 41. As a result, air breakdown is caused and the air mixture inside the combustion chamber 46 is ignited. In order to achieve such ignition, an end of an optical fiber 13 of the laser-beam emitting device 10 is connected to the spark plug 52. Note that such end of the optical fiber 13 may be referred to as an optical exit end 13b, and the optical fiber 13 will be described later.

The laser-beam emitting device 10 is fixed at a position close to the engine 41, and in the first embodiment, a heat sink 32 that serves as a cooler 30, as will be described later, is fixed onto an engine outer frame 53 that forms the external diameter of the engine 41, through an attachment supporting unit. The attachment supporting unit may be integrally molded with the engine outer frame 53, or may be formed as a separate element from the engine outer frame 53. Alternatively, the attachment supporting unit may be integrally molded with the heat sink 32.

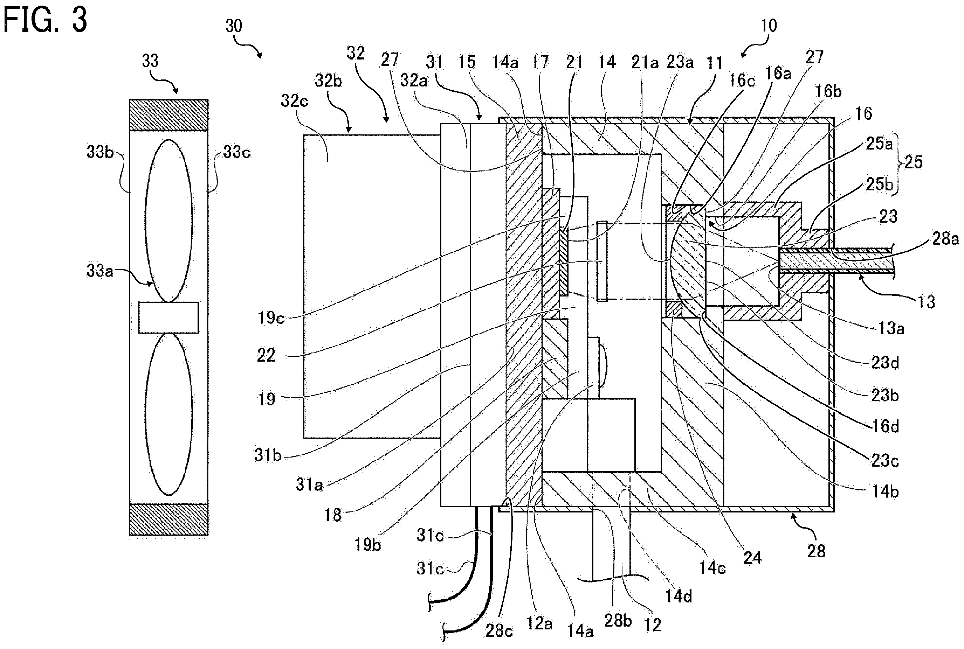

As illustrated in FIG. 2 and FIG. 3, an optical fiber 13 and wires 12 that serve as a conductive material are connected to a housing 11 of the laser-beam emitting device 10. As power is supplied to the laser-beam emitting device 10 through the wires 12 (conductive material), high-power laser beams are output through the optical fiber 13. The housing 11 is provided with a lens holding member 14 that is box-shaped and is open at one end, and a thermal diffusion board 15 that is plate-shaped as a whole. The thermal diffusion board 15 is attached to the lens holding member 14 so as to close the open end of the lens holding member 14.

As illustrated in FIG. 3, the lens holding member 14 has a hollow rectangular-parallelepiped shape as a whole, and one end (14a) of the lens holding member 14 is open and an open end face 14a is coplanar. The lens holding member 14 holds a condenser lens 23 as will be described later, and has a thermal conductivity higher than the thermal conductivity of the condenser lens 23. The lens holding member 14 is made of, for example, a metallic material such as iron, copper, and stainless steel. In the first embodiment, for example, the lens holding member 14 is made of aluminum. A lens holding slot 16 is formed on an inner wall 14b of the lens holding member 14 on the other side of an opening side, and two wire insertion slots 14d are formed on a bottom wall 14c that is orthogonal to the inner wall 14b (note that only one of the wire insertion slots 14d is illustrated in FIG. 3). Each of the wires 12 passes through one of the two wire insertion slots 14d, thereby maintaining hermeticity.

The lens holding slot 16 holds a condenser lens 23, as will be described later, and includes a large diameter portion 16a into which the condenser lens 23 can be inserted, and a small diameter portion 16b that has a smaller interior diameter than the large diameter portion 16a in order to prevent the condenser lens 23 inserted therein from dropping out. An inner surface 16c of the large diameter portion 16a that surrounds the central axis of the lens holding slot 16 and defines the inner circumference is a plane that is parallel to the central axis. Accordingly, the inserted condenser lens 23 can contact an outer surface 23c, as will be described later, across its entire surface. The inner surface 16c of the large diameter portion 16a has a dimension when viewed from the direction of the central axis of the lens holding slot 16 wider than the dimension of the outer surface 23c of the condenser lens 23 when viewed from the direction of the central axis of the lens holding slot 16. Accordingly, the area of the inner surface 16c becomes larger than the area of the outer surface 23c that the condenser lens 23 can contact. In the lens holding slot 16, a step between the large diameter portion 16a and the small diameter portion 16b makes up a back end surface 16d, and the back end surface 16d is a plane that is orthogonal to the central axis of the lens holding slot 16. The thermal diffusion board 15 is attached to the open end (open end face 14a) of the lens holding member 14.

The thermal diffusion board 15 is a base on which a laser array chip 21, as will be described later, is supported in the housing 11. The thermal diffusion board 15 serves to diffuse the heat generated at the laser array chip 21 in an efficient manner, and has a sufficient endothermic area to cool the laser array chip 21. In the first embodiment, the thermal diffusion board 15 is shaped like a flat plate such that the periphery of the thermal diffusion board 15 touches the open end face 14a of the lens holding member 14 across its entire surface, and the thermal diffusion board 15 has a size sufficient to close the open end of the lens holding member 14. The thermal diffusion board 15 has a thermal conductivity equal to or higher than that of the lens holding member 14. For example, the thermal diffusion board 15 is made of a material of high thermal conductivity such as a metallic material, and in the first embodiment, the thermal diffusion board 15 is made of copper.

As illustrated in FIG. 1, FIG. 3, and FIG. 4, a mounting unit 17 is formed on the thermal diffusion board 15 for the implementation of the laser array chip 21, as will be described later. In the first embodiment, the mounting unit 17 is formed by laying an insulating layer on the thermal diffusion board 15 and further laying a plurality of conductive layers, as desired. Note also that these conductive layers are arranged so as not to contact each other. For example, the insulating layer is formed by aluminum nitride (AlN), and the conductive layers are formed by copper (Cu). On the mounting unit 17, a circuit for the laser array chip 21 is formed, and such a circuit is composed of a plurality of conductive layers that are insulated from each other by insulating layers on the thermal diffusion board 15. Moreover, a positioning unit that adjusts the relative positions of the laser array chip 21 is disposed on the mounting unit 17. As long as the positioning unit adjusts the relative positions of the laser array chip 21 by contacting at a prescribed position, the positioning unit may be convex or concave.

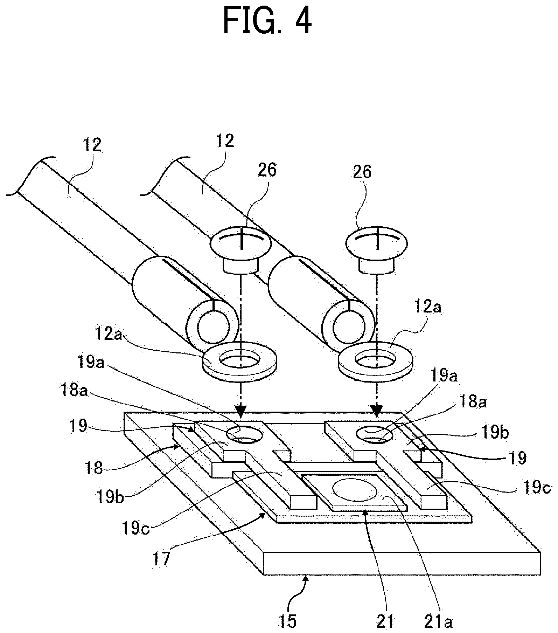

As illustrated in FIG. 3 and FIG. 4, an insulating member 18 is provided for the thermal diffusion board 15. The insulating member 18 cuts electrical conduction with the thermal diffusion board 15, and serves as a portion on which electrodes 19, as will be described later, and the wires 12 are mounted. In the first embodiment, the insulating member 18 is made of an elastically deformable material. In other words, the insulating member 18 is made of material whose modulus of elasticity is low, and at least, the insulating member 18 is more elastically deformable than the mounting unit 17. More desirably, the insulating member 18 absorbs the amount of deformation made by the stress caused by the electrodes 19 when the electrodes 19 are mounted. Such absorption of an amount of deformation is enabled by setting a size or shape in view of the modulus of elasticity of the material. In the first embodiment, the insulating member 18 is made of an insulative resin material, and for example, the insulating member 18 is made of polyoxymethylene (POM). The insulating member 18 is a rectangular parallelepiped, and as will be described later, serves as a portion on which the electrodes 19 and the wires 12 are mounted on the thermal diffusion board 15 and the electrodes 19 and the wires 12 are electrically connected. On the insulating member 18, screw holes 18a for tightening and fastening screws 26, as will be described later, (see FIG. 4) are formed, enabling the attachment of the electrodes 19 and the wires 12.

The wires 12 and the electrodes 19 are electrically connected to each other and are mounted onto the insulating member 18 so as to supply power to the laser array chip 21 disposed on the mounting unit 17. As will be described later, the wires 12 are connected to an external power source, and the electrodes 19 are connected to the laser array chip 21 through the mounting unit 17. In the first embodiment, as will be described later, the laser array chip 21 is assumed to receive a high level of electric current equal to or greater than 100 amperes (A). For this reason, each of the wires 12 and the electrodes 19 are configured to have a sufficient cross-sectional area, and great force is applied to fix the wires 12. To cope with such a situation, for example, ring-shaped connection terminals 12a are provided for the tips of the wires 12. The electrodes 19 are made of a conductive material and are long and plate-shaped. Moreover, a mounting piece 19b having a mounting hole 19a is formed at the edge of each of the electrodes (see FIG. 4). As will be described later, the mounting piece 19b of the electrode 19 is mounted onto the insulating member 18, and a tip 19c on the other side of the mounting piece 19b is pressed against the mounting unit 17.

The laser array chip 21 that is disposed on the mounting unit 17 is configured, for example, as an array of surface-emitting lasers. In the first embodiment, the laser array chip 21 is configured as a plurality of vertical-cavity surface-emitting lasers (VCSEL) as desired. Each of the VCSELs is composed of a cylindrical active region and a reflecting mirror that clamps a thin-film active layer, and emits laser beams from an oscillator that is formed in the direction perpendicular to the principal plane. Each of the VCSELs coats the VCSEL array substrate with a photomask, and the VCSELs are formed in accordance with the patterning of the photomasks. Due to this configuration, the laser array chip 21 requires an input of high level of electric current (i.e., pulse current equal to or greater than 100 amperes (A) in the present embodiment) in order to emit laser beams appropriately from the VCSELs. Accordingly, the laser array chip 21 can output high-power laser beams in spite of its small size.

Once power of a predetermined strength is supplied to the laser array chip 21, the laser array chip 21 uses the VCSELs to emit laser beams through the exit plane 21a. The laser array chip 21 is mounted on the mounting unit 17 upon pressing prescribed portions of the laser array chip 21 against the positioning unit of the mounting unit 17 to effect positioning. Further, the laser array chip 21 is electrically connected to the circuits formed on the mounting unit 17 by, for example, wire bonding or flip-chip bonding. Accordingly, the laser array chip 21 is correctly positioned and disposed on the mounting unit 17 of the thermal diffusion board 15 that serves as a base, and power can be supplied through the wires 12 and the electrodes 19. Instead of pressing the laser array chip 21 against the positioning unit of the mounting unit 17, alternatively the laser array chip 21 may be aligned with the mounting unit 17 by positioning the laser array chip 21 using a microscope to view an alignment mark or the like. A collimator lens 22 is arranged in the light exit direction of the laser beams emitted from the laser array chip 21 (see FIG. 3).

As illustrated in FIG. 3, the collimator lens 22 collimates the laser beams, which are emitted from the exit plane 21a of the laser array chip 21 as a dispersed light flux, to collimated light flux (in actuality, such collimated light flux is loose dispersed light flux). In the first embodiment, the collimator lens 22 is provided with a lens array including a plurality of microlenses that correspond to the VCSELs of the laser array chip 21. Note that the collimator lens 22 may be integrated with the laser array chip 21, and may be mounted on the mounting unit 17 of the thermal diffusion board 15 or the lens holding member 14 in an independent manner from the laser array chip 21. Note also that the collimator lens 22 is satisfactory as long as it collimates the laser beams emitted from the laser array chip 21, and no limitation is intended by the configuration of the first embodiment. A condenser lens 23 is arranged in the direction of travel of the laser beams collimated by the collimator lens 22.

The condenser lens 23 is made of a glass material. The condenser lens 23 concentrates the collimated laser beams that have passed through the collimator lens 22 so as to enter an optical input end 13a of the optical fiber 13. In other words, in the first embodiment, the condenser lens 23 concentrates the laser beams emitted from the laser array chip 21 to a prescribed position, i.e., the optical input end 13a of the optical fiber 13. In the first embodiment, the condenser lens 23 has a planoconvex shape where a side on the collimator lens 22 side is a convex surface 23a and a side on the other side is a plane 23b, and an outer surface 23c that encompasses the optical axis and connects the convex surface 23a to the plane 23b is a plane that is parallel to the optical axis. In the condenser lens 23, an antireflective coating film 23d covers the exterior surface consisting of the convex surface 23a, the plane 23b, and the outer surface 23c. The antireflective coating film 23d is arranged for preventing a decrease in light quantity due to Fresnel reflection. In the first embodiment, the antireflective coating film 23d undergoes anti-reflection (AR) coatings.

In the first embodiment, the condenser lens 23 is fixed to the lens holding slot 16 formed on the inner wall 14b of the lens holding member 14 to effect positioning. More specifically, the condenser lens 23 is inserted into the large diameter portion 16a of the lens holding slot 16 from the plane 23b side, where the outer surface 23c contacts the inner surface 16c of the large diameter portion 16a across its entire surface and the plane 23b of the condenser lens 23 contacts the back end surface 16d of the lens holding slot 16 across its entire surface. Accordingly, the relative positions of the condenser lens 23 when viewed from the direction of the optical axis (central axis) are determined in the lens holding slot 16 in a state where the optical axis matches the central axis of the lens holding slot 16. Then, a pressure ring 24 is inserted into the large diameter portion 16a of the lens holding slot 16 from the rear side of the condenser lens 23 on the collimator lens 22 side, and the pressure ring 24 is pressed against the convex surface 23a of the condenser lens 23 so as to be fixed thereto. Accordingly, the condenser lens 23 is fixed onto the lens holding slot 16. Accordingly, the condenser lens 23 is fixed to the lens holding member 14 to effect accurate positioning. The optical input end 13a of the optical fiber 13 is arranged in the directions of travel of the laser beams that have passed through the condenser lens 23 as concentrated light flux. Note also that the pressure ring 24 and the small diameter portion 16b (the back end surface 16d) have diameters so as to contact the periphery of the effective diameter (effective light flux diameter) of the condenser lens 23.

As illustrated in FIG. 3, the optical fiber 13 includes an optical input end 13a on one end and an optical exit end 13b on the other end (see FIG. 1), and emit the laser beams incident on the optical input end 13a (one end) from the optical exit end (the other end). The other end (i.e., the optical exit end 13b) is connected to an external device that uses laser beams such as a laser beam machine and a spark plug for engines. In the first embodiment, the optical exit end 13b is connected to the spark plug 52 (see FIG. 1) as described above. The optical fiber 13 is supported by an optical fiber supporting member 25, and is attached to the lens holding member 14.

The optical fiber supporting member 25 includes a cylindrical mounting base 25a with a wide diameter, and a cylindrical supporting tube 25b with a narrow diameter. Note that the central axis of the mounting base 25a matches the central axis of the supporting tube 25b. The mounting base 25a has outer dimensions sufficient to close the lens holding slot 16 of the inner wall 14b. The supporting tube 25b has an internal diameter such that the optical fiber 13 can be inserted therein. In the first embodiment, the optical fiber 13 passes through the supporting tube 25b while maintaining the hermeticity. The optical fiber 13 is inserted into the supporting tube 25b, and the optical fiber supporting member 25 is fixed onto the inner wall 14b of the lens holding member 14. In other words, the optical fiber supporting member 25 enables the optical fiber 13 to match the central axis of the optical input end 13a with the central axis of the lens holding slot 16 (i.e., the central axis of the condenser lens 23), and the distance between the optical input end 13a and the condenser lens 23 is appropriately maintained. Accordingly, the laser beams that have passed through the condenser lens 23 as concentrated light flux enters the optical input end 13a of the optical fiber 13 in an appropriate manner.

For example, the laser-beam emitting device 10 is installed as follows. As illustrated in FIG. 3 and FIG. 4, firstly, the laser array chip 21 is set on the mounting unit 17 of the thermal diffusion board 15 upon adjusting the relative positions of the laser array chip 21 and the mounting unit 17, and while the tip 19c is being pressed against the mounting unit 17, the mounting piece 19b is disposed on the insulating member 18. By so doing, the electrodes 19 are provided. Then, the connection terminals 12a of the wires 12 that have passed through the wire insertion slot 14d (see FIG. 3) on the bottom wall 14c of the lens holding member 14 are disposed on the mounting pieces 19b insulating member 18 (see FIG. 4). Then, as illustrated in FIG. 4, the fastening screws 26 that are drawn through the ring-shaped connection terminals 12a of the wires 12 and the mounting holes 19a of the mounting pieces 19b of the electrodes 19 are screwed into the screw holes 18a in the insulating member 18, and the wires 12 and the electrodes 19 are attached to the insulating member 18. As a result, the connection terminals 12a of the wires 12 are electrically connected to the mounting pieces 19b of the electrodes 19, and the tips 19c of the electrodes 19 are pressed against the mounting unit 17. Accordingly, the laser array chip 21 that is implemented on the mounting unit 17 is electrically connected to the connection terminals 12a of the wires through the mounting unit 17 and the electrodes 19.

As illustrated in FIG. 3, the condenser lens 23 is inserted from the plane 23b side to the large diameter portion 16a of the lens holding slot 16 on the inner wall 14b of the lens holding member 14 such that the outer surface 23c contacts the inner surface 16c across its entire surface and the plane 23b contacts the back end surface 16d by surface to effect positioning. In so doing, it is desired that heat exchanger grease 27 be placed between the inner surface 16c and the back end surface 16d of the lens holding slot 16 and the outer surface 23c and plane 23b of the condenser lens 23. The heat exchanger grease 27 is a lubricant made of a material with high thermal conductivity, and in the first embodiment, silicon grease is used for the heat exchanger grease 27. Then, a pressure ring 24 is inserted into the lens holding slot 16 from the back of the condenser lens 23 on the collimator lens 22 side, and the pressure ring 24 is pressed against the convex surface 23a of the condenser lens 23 so as to be fixed thereto. Accordingly, the condenser lens 23 is fixed onto the lens holding slot 16 to effect positioning. Note that a sealing member, as will be described later, may be provided between the condenser lens 23 and the lens holding slot 16, as desired.

Next, the mounting base 25a of the optical fiber supporting member 25 where the optical fiber 13 is inserted into the supporting tube 25b is attached to the inner wall 14b of the lens holding member 14. In so doing, a sealing member such as an elastic body is placed between the mounting base 25a of the optical fiber supporting member 25 and the inner wall 14b of the lens holding member 14. Afterward, the collimator lens 22 is arranged as desired, and the periphery of the thermal diffusion board 15 is pressed against the open end face 14a of the lens holding member 14. Accordingly, the thermal diffusion board 15 can be attached while closing the open end of the lens holding member 14. In so doing, a sealing member such as an elastic body and the heat exchanger grease 27 are placed between the open end face 14a of the lens holding member 14 and the periphery of the thermal diffusion board 15. Accordingly, the lens holding member 14 can be attached to the thermal diffusion board 15 in a hermetically-sealed manner with only slight thermal resistance. The heat exchanger grease 27 that is placed between the inner surface 16c and the back end surface 16d of the lens holding slot 16 and the outer surface 23c and plane 23b of the condenser lens 23, and the heat exchanger grease 27 that is placed between the open end face 14a of the lens holding member 14 and the thermal diffusion board 15, serve as a heat transfer accelerator that reduces thermal resistance therebetween. Such a heat transfer accelerator is satisfactory as long as it is placed between the lens holding slot 16 and the condenser lens 23 or placed between the lens holding member 14 and the thermal diffusion board 15 to reduce the thermal resistance therebetween, and the heat transfer accelerator is not limited to the configuration according to the first embodiment.

As described above, the laser-beam emitting device 10 is installed as illustrated in FIG. 2 and FIG. 3. In the laser-beam emitting device 10 according to the present embodiment, the housing 11 is hermetically sealed by the lens holding member 14, the thermal diffusion board 15, and the optical fiber supporting member 25. In other words, the lens holding member 14 that serves as a holding member and the thermal diffusion board 15 that serves as a base together configure a part of the housing 11 and together configure a part of the outer frame of the laser-beam emitting device 10. Assuming that the thermal diffusion board 15 is a first outer frame and the lens holding member 14 is a second outer frame, the thermal diffusion board 15 and the lens holding member 14 together configure an entire outer frame of the housing 11, and the optical fiber 13 is attached to the optical fiber supporting member 25 that serves as a third outer frame. In this configuration, the housing 11 is hermetically sealed. In the housing 11, the wires 12 pass through the wire insertion slot 14d (see FIG. 3) formed on the bottom wall 14c of the lens holding member 14, and the wires 12 that are extended from the housing 11 are connected to an external power source. Further, the laser array chip 21 to which power is supplied from the power source through the wires 12 is installed inside the housing 11 of the laser-beam emitting device 10. In the first embodiment, as described above, the wires 12 are extended from the housing 11 to the outside. However, alternatively electrodes such as the electrodes 19 may be extended from the housing 11 to the outside thereof, and no limitation is intended thereby.

In the laser-beam emitting device 10 according to the present embodiment, the laser array chip 21 is supplied with power through the mounting unit 17, the electrodes 19, and the wires 12 that are connected to an external power supply. Then, laser beams are emitted from the exit plane 21a of the laser array chip 21 as a dispersed laser-beam bundle, and the laser beams are collimated to be a collimated laser-beam bundle by the collimator lens 22 and travels forward to the condenser lens 23. In the laser-beam emitting device 10, the collimated laser-beam bundle is concentrated to the optical input end 13a of the optical fiber 13 by the condenser lens 23, and the laser beams are output from the optical exit end 13b (see FIG. 1) to the outside through the optical fiber 13. Due to this configuration, in the laser-beam emitting device 10, high-power laser beams can be output to a device that uses laser beams (i.e., the spark plug 52 in the first embodiment (see FIG. 1)) that is connected to the other end (i.e., the optical exit end 13b) of the optical fiber 13. As described above, in the laser-beam emitting device 10, the laser array chip 21 that is mounted on the thermal diffusion board 15 serves as a laser-beam source unit.

In the present embodiment, in order for the laser-beam emitting device 10 to output high-power laser beams in spite of its small size, the laser array chip 21 for which a plurality of vertical-cavity surface-emitting lasers (VCSEL) are provided is used. In the laser-beam emitting device 10 according to the present embodiment, in order to operate the laser array chip 21 appropriately, i.e., in order for the VCSELs to emit laser beams appropriately, high level of electric current (i.e., 100 amperes (A) or greater in the present embodiment) is applied. For this reason, heat is generated as the laser array chip 21 is operated. However, there is some concern that the useful life is prematurely shortened and the output power drops when the temperature gets high. Due to such circumstances, the laser array chip 21 is to be cooled appropriately during operation.

For the reasons as described above, in the laser-beam emitting device 10, the laser array chip 21 that serves as a laser-beam source unit is provided with an endothermic unit of the cooler 30, and the heat that is absorbed by the endothermic unit is dissipated by a heat-dissipating unit of the cooler 30. Accordingly, the laser array chip 21 is cooled. The cooler 30 may be, for example, the forced convection that is produced at an air-cooled heat sink by the airflow from an air-blowing fan. Note also that the air-cooled heat sink serves as a heat-dissipating member and the air-blowing fan serves as an air-blowing mechanism. For example, when the temperature of an object to which the heat sink (heat-dissipating member) dissipates the heat cannot be lowered sufficiently by the cooler 30, a thermionic element such as a Peltier element is disposed between the thermal diffusion board 15 and the heat sink.

In the laser-beam emitting device 10 according to the first embodiment, the cooler 30 includes the thermal diffusion board 15 that configures a part of the housing 11 (i.e., the outer frame) of the laser-beam emitting device 10, a Peltier element 31 that serves as a thermionic element, the heat sink 32 that serves as a heat-dissipating member, and the air-blowing fan 33 that serves as an air-blowing mechanism. The cooler 30 provides the thermal diffusion board 15 with the heat sink 32 via the Peltier element 31, and the air-blowing fan 33 generates air flow (blows air) towards a heat-dissipative part 32b, as will be described later, of the heat sink 32. At the cooler 30, the Peltier element 31 that serves as a first coolant cools the thermal diffusion board 15 and the laser array chip 21 disposed on the thermal diffusion board 15. Further, the heat sink 32 that serves as a second coolant cools the Peltier element 31, and Further, the air-blowing fan 33 that serves as a third coolant cools the heat sink 32.

The Peltier element 31 (thermionic element) is disposed between the thermal diffusion board 15 (thermal diffusion member) and the heat sink (heat-dissipating member) 32 in order to cool the laser array chip 21 (laser-beam source unit) to a temperature lower than the ambient temperature. The Peltier element 31 includes a cooling surface 31a that serves as an endothermic part and a heat-dissipative surface 31b that serves as a heat-dissipative part, and the cooling surface 31a and the heat-dissipative surface 31b are provided for the thermal diffusion board 15 and an endothermic part 32a of the heat sink 32, respectively. Note that the endothermic part 32a will be described later. The Peltier element 31 is controlled to have a prescribed temperature difference through power lines 31c. Such a prescribed temperature difference is determined by the temperature of the thermal diffusion board 15 (the laser array chip 21 (laser-beam source unit)) to be maintained at and the temperature (heat) that the heat sink 32 can dissipate. This is because the temperature (heat) that the heat sink 32 can dissipate varies according to the ambient temperature at which a heat-dissipative part 32b of the heat sink 32 is disposed. Note that heat-dissipative part 32b will be described later.

Preferably, the cooling surface 31a of the Peltier element 31 has a size that corresponds to a portion where the open end face 14a of the lens holding member 14 contacts the thermal diffusion board 15 across its entire surface. In other words, the Peltier element 31 has dimensions so as to face the open end face 14a through the thermal diffusion board 15. In the first embodiment, the cooling surface 31a of the Peltier element 31 has a shape and dimensions that are approximately equivalent to those of the outer surface of the thermal diffusion board 15, and the cooling surface 31a is applied to the thermal diffusion board 15 in its entirety and faces the open end face 14a through the thermal diffusion board 15. The same can be said of an endothermic part 32a of the heat sink 32. When the Peltier element 31 is not installed, the endothermic part 32a faces the open end face 14a through the thermal diffusion board 15. Note that the endothermic part 32a will be described later.

The heat sink 32 dissipates the heat on the endothermic part 32a to which the heat-dissipative surface 31b of the Peltier element 31 is applied and heat is transferred, using the heat-dissipative part 32b provided with a plurality of fins (see FIG. 2). The heat sink 32 dissipates the heat in the air around through heat-dissipative part 32b to lower the temperature of the heat-dissipative surface 31b of the Peltier element 31 that is applied to the endothermic part 32a. In the first embodiment, the heat-dissipative part 32b is composed of the multiple fins 32c that extend vertically when viewed from the front in FIG. 2, and these multiple fins 32c are aligned parallel to each other horizontally. In order to cool heat-dissipative part 32b and its fins 32c, an air-blowing fan 33 is also provided.

As illustrated in FIG. 3, the air-blowing fan 33 includes a plurality of blades 33a, a housing, an air taking-in port 33b, and an air-blowing port 33c. The blades 33a are accommodated in the housing in a rotatable manner, and the air taking-in port 33b and the air-blowing port 33c are formed on the housing. As power is supplied to the air-blowing fan 33 and the blades 33a are driven to rotate, the air-blowing fan 33 takes in the air around from the air taking-in port 33b, and sends out the taken-in air from the air-blowing port 33c in a prescribed direction. Accordingly, airflow is generated in a prescribed direction. The air-blowing port 33c of the air-blowing fan 33 is disposed so as to face heat-dissipative part 32b of the heat sink 32, and causes forced convection at heat-dissipative part 32b to enhance the heat conduction.

Due to this configuration, in the laser-beam emitting device 10 according to the first embodiment, the thermal diffusion board 15 that configures a part of the housing 11 also serves as the cooler 30. Moreover, in the laser-beam emitting device 10 according to the present embodiment, the thermal diffusion board 15 that diffuses the heat of the disposed laser array chip 21 and the endothermic part 32a that faces the Peltier element 31 applied to the thermal diffusion board 15 serve as an endothermic unit of the cooler 30. Further, in the laser-beam emitting device 10 according to the first embodiment, the heat-dissipative surface 31b of the Peltier element 31, the heat sink 32 to which the heat-dissipative surface 31b is applied, and the air-blowing fan 33 that causes forced convection at heat-dissipative part 32b serve as a heat-dissipating unit of the cooler 30.

In addition, in the in the laser-beam emitting device 10 according to the first embodiment, an exterior component 28 surrounds the lens holding member 14. The exterior component 28 prevents the heat from flowing into the lens holding member 14 from the environment (ambient atmosphere) where the housing 11 (i.e., the lens holding member 14) of the laser-beam emitting device 10 is installed. The exterior component 28 has a thermal conductivity lower than that of the lens holding member 14, and is made of a plastic resin in the first embodiment. In the first embodiment, the exterior component 28 contacts the exterior surface of the lens holding member 14, and is a rectangular parallelepiped that is open at one end and surrounds the lens holding member 14 and the optical fiber supporting member 25. Moreover, the exterior component 28 includes an optical fiber slot 28a, a wire slot 28b, and a cooling slot 28c. The optical fiber slot 28a is supported by the optical fiber supporting member 25, and the optical fiber 13 that extends from the lens holding member 14 passes through the optical fiber slot 28a. The wires 12 that extend from the wire insertion slots 14d of the lens holding member 14 to the outside of the housing 11 pass through the wire slot 28b. The cooler 30 that cools the laser array chip 21 (i.e., the laser-beam source unit) passes through the cooling slot 28c, and is an open end. In the first embodiment, the cooling slot 28c contacts the cooling surface 31a (endothermic part) of the Peltier element 31. In other words, the exterior component 28 covers the lens holding member 14 in its entirety together with the condenser lens 23 held by the lens holding member 14, and covers the endothermic unit of the cooler 30 to which the lens holding member 14 is applied. In a state where the housing 11 (the lens holding member 14) and the optical fiber supporting member 25 are surrounded by the exterior component 28, the laser-beam emitting device 10 is supplied with power from a power supply through the wires 12, and emits high-power laser beams from the other end (the optical exit end) of the optical fiber 13.

As illustrated in FIG. 1, the laser-beam emitting device 10 according to the present embodiment configures a part of the engine spark plug system 40, and is used in an internal combustion engine 41. In the engine spark plug system 40, once the laser-beam emitting device 10 is activated, the laser beams that are output from the laser array chip 21 are collimated to be a collimated laser-beam bundle by the collimator lens 22 and the collimated laser beams are concentrated by the condenser lens 23 and enter the optical input end 13a of the optical fiber 13. Then, the laser beams pass through the optical fiber 13 and enter the spark plug 52 through the optical exit end 13b. Further, the spark plug 52 irradiates laser resonator with the laser beams to resonate a giant pulse, and the pulsed light is concentrated by an optical element onto the combustion chamber 46 of the engine 41 to cause air breakdown. Accordingly, the air mixture inside the combustion chamber 46 is ignited in the engine spark plug system 40 to drive the piston 47.

For example, in an environment where the engine 41 is arranged as in an engine room, the temperature increased mainly due to the heat generated by the engine 41. In the laser-beam emitting device 10, the heat sink 32 that serves as a heat-dissipating member in the cooler 30 uses the heat-dissipative part 32b to release heat into the air (atmosphere) around the engine 41. Accordingly, the cooling capability depends on the temperature of the air around the engine 41. In the present embodiment, an increase in temperature around the engine 41 is controlled by the cooling water 51 that is supplied to the cooling water channel 49 or the heat dissipation into the air. However, the temperature increases due to the engine outer frame 53 of the engine 41 that generates heat due to combustion. For this reason, it is too hot to install the laser array chip 21 (i.e., the laser-beam source unit). In view of the above circumstances, in the laser-beam emitting device 10 according to the first embodiment, the Peltier element 31 (thermionic element) is used as the cooler 30 in combination with the thermal diffusion board 15 (thermal diffusion member), the heat sink 32 (heat-dissipating member), and the air-blowing fan 33 (air-blowing mechanism).

In the laser-beam emitting device 10 according to the present embodiment, the air-blowing fan 33 takes in the air around from the air taking-in port 33b, and generates airflow. Accordingly, the temperature of the airflow from the air-blowing fan 33 is the temperature around the engine 41. For this reason, in the laser-beam emitting device 10, a temperature difference ΔT between both sides (the cooling surface 31a and the heat-dissipative surface 31b) of the Peltier element 31 is controlled such that the temperature of the heat sink 32 becomes higher than the temperature of the air blown from the air-blowing fan 33 (i.e., the temperature around the engine 41). Accordingly, in the laser-beam emitting device 10, even if the temperature of the heat sink 32 is higher than the temperature of the air blown from the air-blowing fan 33, the heat-dissipative surface 31b of the Peltier element 31 (see FIG. 3) can be cooled, and the cooling surface 31a of the Peltier element 31 (see FIG. 3) can be cooled to a temperature sufficient to cool the laser array chip 21. Due to this configuration, in the laser-beam emitting device 10, even if the temperature of the atmosphere is too hot to install the laser array chip 21 (i.e., the laser-beam source unit), the laser array chip 21 can be cooled to a temperature equal to or lower than a target temperature.

In the laser-beam emitting device 10 according to the present embodiment, the laser array chip 21 outputs high-power laser beams (large amount of light). For this reason, there is some concern that the condenser lens 23 that concentrates the laser beams absorbs some of the laser beams as heat energy and the temperature of the condenser lens 23 increases. In such cases, there is some concern that the condenser lens 23 cannot concentrate the laser beams to a desired position (i.e., the optical input end 13a of the optical fiber 13 in the first embodiment) as the optical performance depends on the temperature. The temperature dependence of the optical performance of the condenser lens 23 is considered to come from the changes in refractive index or shape due to the temperature change at the condenser lens 23. In the laser-beam emitting device 10, when the laser beams cannot be concentrated to the optical input end 13a of the optical fiber 13 appropriately, not all the light flux of the laser beams that are emitted from the laser array chip 21 can enter (strike) the optical input end 13a, and the utilization efficiency of the laser beams deteriorates. For this reason, in the laser-beam emitting device 10, even if the laser array chip 21 (i.e., the laser-beam source unit) is appropriately driven, there is some concern that a target amount of light cannot be output appropriately.

By contrast, in the laser-beam emitting device 10, the lens holding member 14 holds the condenser lens 23, and has a thermal conductivity higher than the thermal conductivity of the condenser lens 23, and contacts the condenser lens 23 and the cooler 30 (i.e., the thermal diffusion board 15 in the first embodiment) across its entire surface. For this reason, in the laser-beam emitting device 10, the heat of the condenser lens 23 is efficiently conducted to the lens holding member 14, and the conducted heat is diffused by the lens holding member 14. Then, the lens holding member 14 is efficiently cooled by the cooler 30. Due to this configuration, in the laser-beam emitting device 10, even if the condenser lens 23 absorbs some of the laser beams as heat energy, the cooler 30 can cool the condenser lens 23 through the lens holding member 14. Accordingly, the temperature of the condenser lens 23 can effectively be prevented from increasing.

In the laser-beam emitting device 10 according to the present embodiment, the lens holding member 14 has a high thermal conductivity higher. For this reason, if the ambient atmosphere is too hot, the heat may flow into the lens holding member 14 from the ambient atmosphere, and it may lead to an increasing burden on the cooler 30. Moreover, the laser array chip 21 (i.e., the laser-beam source unit) may no longer be cooled appropriately, or the temperature of the condenser lens 23 may increase. Assuming that the heat that flows into the lens holding member 14 is Q watts (W) of power, compared with when no heat flows into the lens holding member 14, the Peltier element 31 requires an increased amount of power by about 3Q(W) power. In particular, the laser-beam emitting device 10 according to the first embodiment is installed in a high-temperature environment where the engine 41 (see FIG. 1) is arranged, and the Peltier element 31 (thermionic element) is disposed to cool the laser array chip 21 (i.e., the laser-beam source unit). For the reasons as described above, there is a high probability that the flow of heat into the lens holding member 14 leads to a problem.

By contrast, in the laser-beam emitting device 10, the exterior component 28 that has a thermal conductivity lower than that of the lens holding member 14 surrounds the lens holding member 14. Accordingly, the lens holding member 14 can be isolated from the heat in the ambient atmosphere. In other words, in the laser-beam emitting device 10, the heat can be prevented from flowing into the lens holding member 14 from the ambient atmosphere. Accordingly, regardless of the temperature of the ambient atmosphere where the laser-beam emitting device 10 is installed, the temperature of the condenser lens 23 can be prevented from increasing. Due to this configuration, in the laser-beam emitting device 10, even if high a level of electric current is supplied under high-temperature environments and the laser array chip 21 (i.e., the laser-beam source unit) is driven, the temperature of the condenser lens 23 can more effectively be prevented from increasing.

In the laser-beam emitting device 10 according to the first embodiment of the present disclosure, the lens holding member 14 has a thermal conductivity higher than the thermal conductivity of the condenser lens 23, and contacts the condenser lens 23 and the cooler 30 (i.e., the thermal diffusion board 15 in the first embodiment) across its entire surface. For this reason, in the laser-beam emitting device 10, the condenser lens 23 and the cooler 30 (i.e., the thermal diffusion board 15) are thermally continuous through the lens holding member 14. Due to this configuration, in the laser-beam emitting device 10, even if the condenser lens 23 absorbs some of the laser beams as heat energy, the cooler 30 can cool the condenser lens 23 through the lens holding member 14. Accordingly, the temperature of the condenser lens 23 can effectively be prevented from increasing. In view of the above circumstances, in the laser-beam emitting device 10, changes in optical performance of the condenser lens 23 due to the changes in, for example, refractive index and shape due to the temperature change can be prevented, and a target amount of light can be output appropriately.

In the laser-beam emitting device 10, the cooler 30 that cools the laser array chip 21 (i.e., the laser-beam source unit) contacts the lens holding member 14 across its entire surface. Accordingly, the temperature of the condenser lens 23 can be prevented from increasing. In view of the above circumstances, in the laser-beam emitting device 10, the laser array chip 21 (i.e., the laser-beam source unit) can appropriately be cooled with a relatively simple configuration that does not require a new coolant added just to reduce a temperature rise at the condenser lens 23, and the temperature of the condenser lens 23 can be prevented from increasing.

Further, in the laser-beam emitting device 10, the lens holding member 14 has a high thermal conductivity higher, and thus even when the condenser lens 23 absorbs heat energy, such heat can be diffused. Accordingly, the build-up of heat around the lens holding slot 16 can be prevented. Moreover, in the laser-beam emitting device 10 according to the present embodiment, the lens holding member 14 contacts the cooler 30 across its entire surface to reduce the temperature rises in its entirety of the lens holding member 14, and the lens holding member 14 in its entirety including the lens holding slot 16 can be prevented from deforming due to the temperature rises. Accordingly, in the laser-beam emitting device 10, concern that the condenser lens 23 cannot concentrate the laser beams to a desired position (i.e., the optical input end 13a of the optical fiber 13 in the first embodiment) due to the misalignment of the condenser lens 23 caused by the deformation at the lens holding slot 16 of the lens holding member 14 can be resolved, and a target amount of light can be output appropriately.

In the laser-beam emitting device 10, the cooler 30 that cools the laser array chip 21 (i.e., the laser-beam source unit)
includes the Peltier element 31 (thermionic element) in addition to the thermal diffusion board 15, the heat sink 32, and the air-blowing fan 33. Accordingly, in the laser-beam emitting device 10, even under high-temperature environments, the temperature difference between both sides of the Peltier element 31 may be controlled such that the laser-beam source unit (i.e., the laser array chip 21) and the condenser lens 23 is cooled by heat dissipation at the heat sink 32. Due to this configuration, in the laser-beam emitting device 10, even under high-temperature environments like an engine room where the engine 41 (see FIG. 1) is arranged, the laser array chip 21 (i.e., the laser-beam source unit) can be cooled to a temperature lower than the ambient temperature, and the temperature of the condenser lens 23 can be prevented from increasing.

In the laser-beam emitting device 10 according to the present embodiment, a planoconvex lens is used as the condenser lens 23, and the plane 23b of the condenser lens 23 contacts the back end surface 16d of the lens holding slot 16 of the lens holding member 14 across its entire surface. Accordingly, the condenser lens 23 contacts the lens holding member 14 across its entire surface. Accordingly, in the laser-beam emitting device 10, the condenser lens 23 can be fixed onto the lens holding slot 16 with a relatively simple configuration, and the condenser lens 23 can contact the lens holding member 14 across its entire surface.

In the laser-beam emitting device 10 according to the present embodiment, the outer surface 23c of the condenser lens 23, which is a planoconvex lens, contacts the inner surface 16c of the large diameter portion 16a of the lens holding slot 16 of the lens holding member 14 across its entire surface. Accordingly, the condenser lens 23 contacts the lens holding member 14 across its entire surface. Accordingly, in the laser-beam emitting device 10, the condenser lens 23 can be fixed onto the lens holding slot 16 with a relatively simple configuration, and the condenser lens 23 can contact the lens holding member 14 across its entire surface. Moreover, in the laser-beam emitting device 10 according to the present embodiment, the plane 23b of the condenser lens 23, which is a planoconvex lens, contacts the back end surface 16d of the lens holding slot 16 of the lens holding member 14 across its entire surface, and the outer surface 23c of the condenser lens 23 contacts the inner surface 16c of the lens holding member 14 across its entire surface. Accordingly, in the laser-beam emitting device 10, an area where the condenser lens 23 contacts the lens holding slot 16 of the lens holding member 14 becomes sufficiently large. In particular, in the laser-beam emitting device 10, the dimension of the inner surface 16c of the lens holding slot 16 when viewed from the direction of the central axis of the lens holding slot 16 is made wider than the dimension of the outer surface 23c of the condenser lens 23 when viewed from the direction of the central axis of the lens holding slot 16. Accordingly, in the laser-beam emitting device 10, the outer surface 23c of the condenser lens 23 can contact the inner surface 16c of the lens holding slot across its entire surface in its entirety, and an area where the condenser lens 23 contacts the inner surface 16c of the lens holding slot 16 can be made sufficiently large. Due to this configuration, in the laser-beam emitting device 10, the path of heat transfer between the condenser lens 23 and the lens holding slot 16 can be made sufficiently large, and the temperature of the condenser lens 23 can more appropriately be prevented from increasing.

In the laser-beam emitting device 10 according to the present embodiment, the condenser lens 23 and the cooler 30 (i.e., the thermal diffusion board 15 in the first embodiment) contact the lens holding member 14 across its entire surface through the heat exchanger grease 27 that serves as a heat transfer accelerator. Accordingly, in the laser-beam emitting device 10, the thermal resistance between the condenser lens 23 and the cooler and the lens holding member 14, where the condenser lens 23 and the cooler 30 contact the lens holding member 14 across its entire surface, can further be reduced. Accordingly, the temperature of the condenser lens 23 can more appropriately be prevented from increasing. In the laser-beam emitting device 10, the heat exchanger grease 27 that serves as a heat transfer accelerator is used. Accordingly, the condenser lens 23 can be inserted into the lens holding slot 16 more smoothly.

In the laser-beam emitting device 10 according to the present embodiment, the antireflective coating film 23d covers the exterior surface of the condenser lens 23 consisting of the convex surface 23a, the plane 23b, and the outer surface 23c. Under such conditions, thermal stress may be caused to the antireflective coating film 23d due to a difference in thermal expansion with the condenser lens 23 caused by a temperature rise, or the antireflective coating film 23d may deteriorate due to a temperature rise. In such cases, there is some concern that the capability cannot be exerted appropriately. In the laser-beam emitting device 10 according to the present embodiment, the lens holding member 14 contacts the antireflective coating film 23d that is formed on the exterior surface of the condenser lens 23. Accordingly, temperature of the antireflective coating film 23d can be prevented from increasing. Due to this configuration, in the laser-beam emitting device 10, changes in optical performance of the condenser lens 23 due to a temperature rise can be prevented, and the concern that the capability cannot be exerted appropriately due to a temperature rise on the antireflective coating film 23d is prevented and a target amount of light can more appropriately be output.

In the laser-beam emitting device 10 according to the present embodiment, the exterior component 28 that has a thermal conductivity lower than that of the lens holding member 14 surrounds the lens holding member 14. Accordingly, in the laser-beam emitting device 10, even under high-temperature conditions, the heat can be prevented from flowing into the lens holding member 14 from the environment (ambient atmosphere). Due to this configuration, in the laser-beam emitting device 10, regardless of the temperature of the ambient atmosphere where the laser-beam emitting device 10 is installed, the heat can be prevented from flowing into the lens holding member 14 from the ambient atmosphere and the temperature of the condenser lens 23 can appropriately be prevented from increasing.

In the laser-beam emitting device 10, the heat can be prevented from flowing into the lens holding member 14 from the ambient atmosphere. Accordingly, the burden on the cooler 30 (mainly, the Peltier element 31 (thermionic element)) can be prevented from increasing, and the laser array chip 21 (i.e., the laser-beam source unit) can appropriately be cooled. In particular, in the laser-beam emitting device 10, the exterior component 28 surrounds the condenser lens 23 and the optical fiber supporting member 25 together with the lens holding member 14. Accordingly, in the laser-beam emitting device 10, the heat in the ambient atmosphere can be prevented from flowing into the condenser lens 23 and the heat can be prevented from flowing into the lens holding member 14 or the condenser lens 23 through the optical fiber supporting member 25, and temperature of the condenser lens 23 can more appropriately be prevented from increasing.

In the laser-beam emitting device 10 according to the present embodiment, the exterior component 28 surrounds the lens holding member 14 and the optical fiber supporting member 25. Accordingly, in the laser-beam emitting device 10, even when the optical fiber supporting member 25 is made of a material with a high thermal conductivity such as a metallic material in order to support the optical fiber 13 appropriately, the heat can be prevented from flowing into the optical fiber supporting member 25 from the environment (ambient atmosphere).

In the laser-beam emitting device 10 according to the present embodiment, the cooling slot 28c of the exterior component 28 contacts the cooling surface 31a (endothermic part) of the Peltier element 31 that serves as an endothermic unit in the cooler 30, and an exterior component 28 surrounds the lens holding member 14. In the laser-beam emitting device 10 according to the present embodiment, the Peltier element 31 (thermionic element) is disposed to cool the laser array chip 21 (i.e., the laser-beam source unit) or the lens holding member 14 to a temperature lower than the ambient temperature. Accordingly, in the laser-beam emitting device 10, cold portions (endothermic unit) of the cooler 30 can be blocked from the heat of the ambient atmosphere, together with the lens holding member 14 that is cooled by the cooler 30, and the temperature of the condenser lens 23 can more appropriately be prevented from increasing.

In the laser-beam emitting device 10 according to the present embodiment, the laser-beam source unit includes the laser array chip 21 on which a plurality of surface-emitting lasers are arranged. If the surface-emitting semiconductor laser is arranged with high density, the heat sources are concentrated and heat is generated with high density. However, in the laser-beam emitting device 10, the cooler 30 (i.e., the thermal diffusion board 15 in the first embodiment) is applied to the laser array chip 21 (i.e., the laser-beam source unit), and the lens holding member 14 contacts the cooler 30 (i.e., the thermal diffusion board 15) across its entire surface. Accordingly, in the laser-beam emitting device 10, the laser array chip 21 (i.e., the laser-beam source unit) can appropriately be cooled, and the temperature of the condenser lens 23 can appropriately be prevented from increasing. In particular, in the laser-beam emitting device 10, the mounting unit 17 on which the laser array chip 21 is mounted is near the center of the cooling surface 31a of the Peltier element 31 where the cooling strength is highest in the cooler 30. The same can be said of the heat sink 32. Moreover, in the laser-beam emitting device 10 according to the present embodiment, the open end face 14a of the lens holding member 14 contacts the periphery of the cooling surface 31a of the cooler 30 across its entire surface. Accordingly, in the laser-beam emitting device 10, the laser array chip 21 (i.e., the laser-beam source unit) where cooling is most required is cooled by the center position of the cooling function of the cooler 30. Accordingly, the condenser lens 23 can more appropriately be cooled with only a small loss in the cooling capability of the laser-beam source unit (i.e., the laser array chip 21).

In the laser-beam emitting device 10 according to the present embodiment, the thermal diffusion board 15 on which the laser array chip 21 (i.e., the laser-beam source unit) is mounted contacts the open end face 14a of the lens holding member 14 across its entire surface. Accordingly, in the laser-beam emitting device 10, the cooling surface 31a of the Peltier element 31 can be applied onto the entirety of the thermal diffusion board 15. Accordingly, the laser array chip 21 (i.e., the laser-beam source unit) and the condenser lens 23 can appropriately be cooled through the thermal diffusion board 15.

In the engine spark plug system 40 according to the embodiments of the present disclosure, the laser-beam source unit (i.e., the laser array chip 21) and the condenser lens 23 can appropriately be cooled. Accordingly, in the engine spark plug system 40, the useful life of the laser-beam source unit (i.e., the laser array chip 21) can be prevented from being prematurely shortened and the output power can be prevented from being reduced even under high-temperature environments, and the engine 41 that is an example of internal combustion engine can appropriately ignited.

Accordingly, in the laser-beam emitting device 10 according to the first embodiment of the present disclosure, even when the condenser lens 23 concentrates high-power laser beams, the temperature of the condenser lens 23 can be prevented from increasing.

The laser-beam emitting device 10 according to the first embodiment of the present disclosure has been described as above. However, a laser-beam emitting device is satisfactory as long as it includes a laser-beam source unit configured to emit a laser beam, a condenser lens configured to concentrate the laser beam emitted from the laser-beam source unit onto a prescribed position, a holding member configured to contact the condenser lens across its entire surface and hold the condenser lens, and a cooler applied to the laser-beam source unit to cool the laser-beam source unit, and the holding member has a thermal conductivity higher than a thermal conductivity of the condenser lens, and contacts the cooler across its entire surface. No limitation is intended thereby.

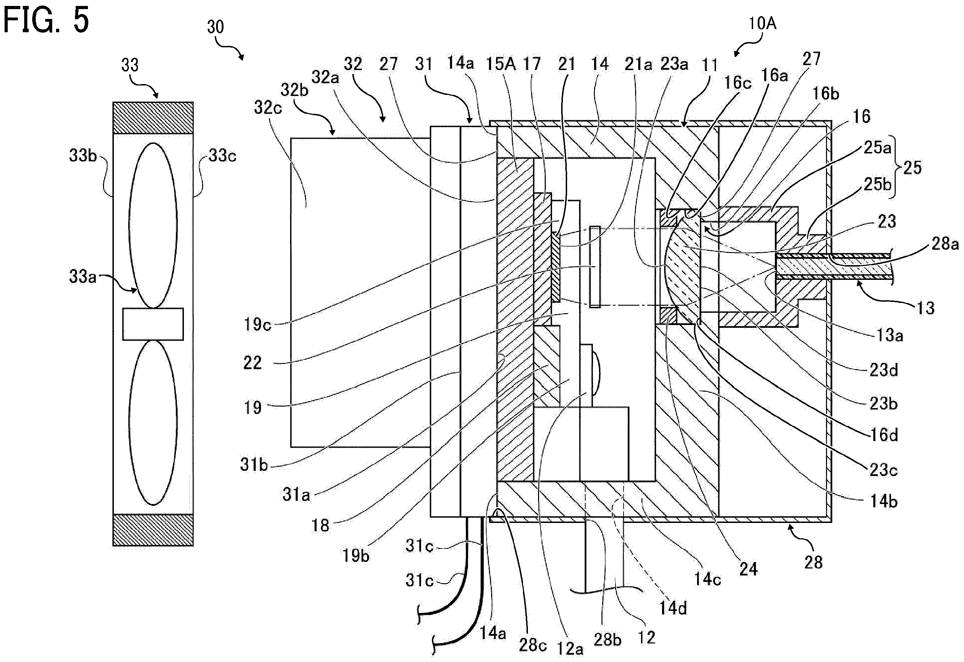

In the first embodiment as described above, the open end face 14a of the lens holding member 14 contacts the thermal diffusion board 15, which also serves as a part of the cooler 30, across its entire surface. However, alternatively a laser-beam emitting device 10A as illustrated in FIG. 5 may be adopted. In the laser-beam emitting device 10A, the size of the thermal diffusion board 15A is small enough to be inserted into the inner space of the lens holding member 14, and the open end face 14a of the lens holding member 14 contacts the endothermic part 32a of the heat sink 32, which also serves as a part of the cooler 30, across its entire surface. As the configuration of the laser-beam emitting device 10A is basically similar to that of the laser-beam emitting device 10 according to the first embodiment, basically, effects similar to those achieved by the first embodiment can be achieved in the laser-beam emitting device 10A. Furthermore, in the laser-beam emitting device 10A according to the present alternative embodiment, the periphery of the cooling surface 31a of the Peltier element 31 has a relatively low cooling strength. However, the open end face 14a of the lens holding member 14 directly contacts the periphery of the Peltier element 31. Accordingly, the temperature of the condenser lens 23 can more appropriately be prevented from increasing.

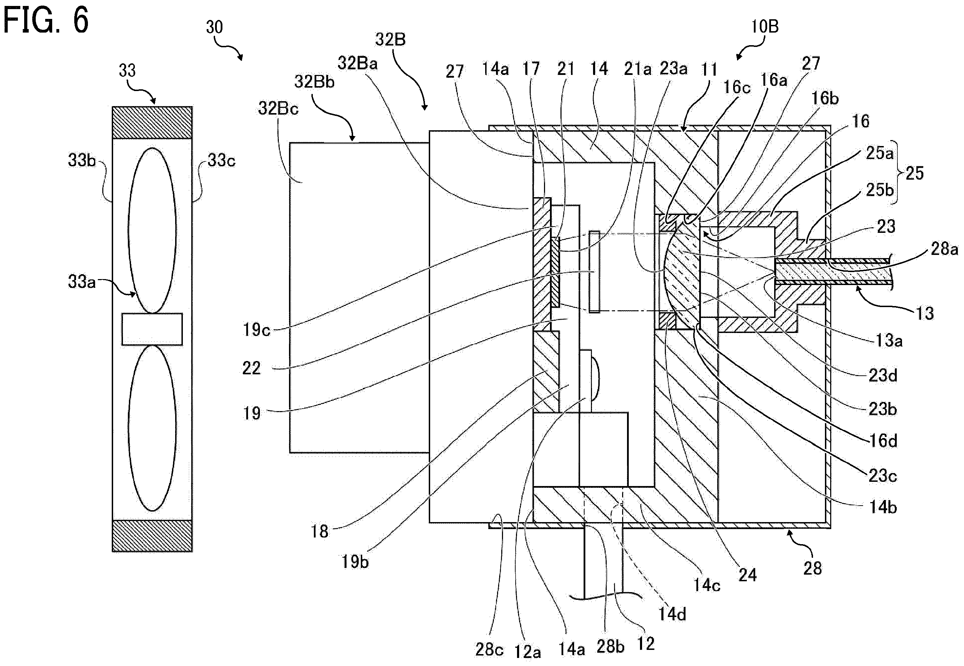

Furthermore, in the first embodiment as described above, the thermal diffusion board 15 is independent of the heat sink 32 in the cooler 30. However, alternatively a laser-beam emitting device 10B as illustrated in FIG. 6 may be adopted. In the laser-beam emitting device 10B, a heat sink 32B where the thermal diffusion board 15 is integrated into the heat sink 32 is used, and the laser array chip 21 is mounted on an endothermic part 32Ba of the heat sink 32B. In a similar manner to the thermal diffusion board 15, the heat sink 32B also serves to diffuse the heat generated at the laser array chip 21 in an efficient manner, and for example, such a function is achieved as the heat sink 32B is made of a material of high thermal conductivity such as a metallic material. In the example of FIG. 6, the heat sink 32B is made of copper. As the configuration of the laser-beam emitting device 10B is basically similar to that of the laser-beam emitting device 10 according to the first embodiment, basically, effects similar to those achieved by the first embodiment can be achieved in the laser-beam emitting device 10B. Furthermore, in the laser-beam emitting device 10B according to the present alternative embodiment, the thermal resistance between thermal diffusion board 15 and the heat sink 32 can be reduced in the laser-beam emitting device 10 with a relatively simple configuration. Moreover, the laser array chip 21 (i.e., the laser-beam source unit) can more appropriately be cooled, and the temperature of the condenser lens 23 can more appropriately be prevented from increasing. Note also that even when the heat sink 32B is adopted, as in the laser-beam emitting device 10A illustrated in FIG. 5, the open end face 14a of the lens holding member 14 may directly contact the endothermic part 32Ba of the heat sink 32B.

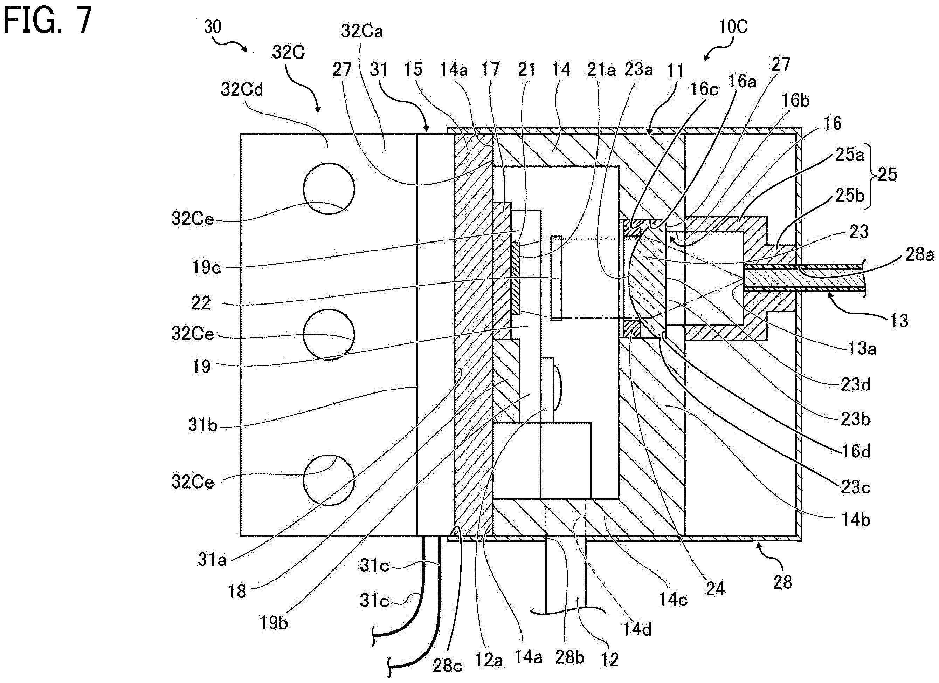

In the first embodiment as described above, the air-cooled heat sink 32 is used as a part of the cooler 30. However, alternatively a laser-beam emitting device 10C as illustrated in FIG. 7 may be adopted. In the laser-beam emitting device 10C, a liquid-cooled heat sink 32C is used. In the heat sink 32C, an endothermic part 32Ca is determined by an endothermic block 32Cd on which coolant channels 32Ce are formed, and cooling water is supplied to the coolant channels 32Ce as desired. Such cooling water may be given from the cooling water 51 that is supplied to the cooling water channel 49 of the engine spark plug system 40, or may be supplied independently. As the configuration of the laser-beam emitting device 10B is similar to that of the laser-beam emitting device 10 according to the first embodiment in the other respects, basically, effects similar to those achieved by the first embodiment can be achieved in the laser-beam emitting device 10C. Note also that even when the heat sink 32C is adopted, as in the laser-beam emitting device 10A illustrated in FIG. 5, the open end face 14a of the lens holding member 14 may directly contact the endothermic part 32Ca of the heat sink 32C.

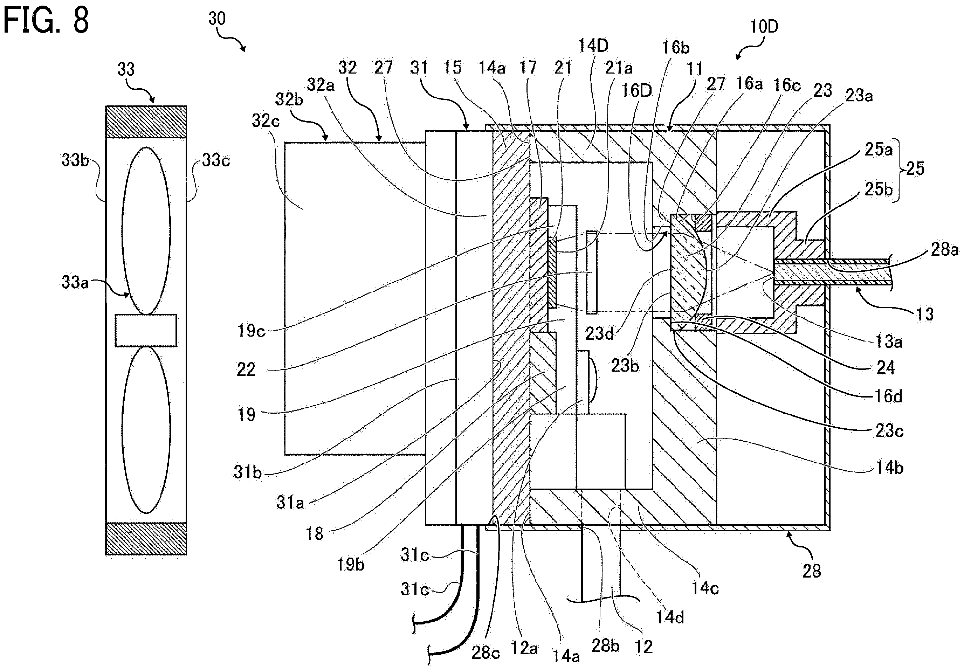

In the first embodiment as described above and the alternative embodiments illustrated in FIG. 5 to FIG. 7, the condenser lens 23 is inserted into the lens holding slot 16 of the lens holding member 14 from the laser array chip 21 (i.e., the laser-beam source unit) side. However, alternatively a laser-beam emitting device 10D as illustrated in FIG. 8 may be adopted. In the laser-beam emitting device 10D, a lens holding slot 16D of a lens holding member 14D is arranged in a direction opposite the lens holding slot 16 of the laser-beam emitting device 10 according to the first embodiment when viewed from optical-axis direction, and the plane 23b of the condenser lens 23 is inserted into the lens holding slot 16D from the outer side of the lens holding member 14D. As the configuration of the laser-beam emitting device 10D is similar to that of the laser-beam emitting device 10 according to the first embodiment in the other respects, basically, effects similar to those achieved by the first embodiment can be achieved in the laser-beam emitting device 10D. Even in such cases where the direction of the condenser lens 23 is opposite, as in the laser-beam emitting device 10A illustrated in FIG. 5, the open end face 14a of the lens holding member 14 may directly contact the endothermic part 32Ca of the heat sink 32C. Moreover, the integrated heat sink 32B as in the laser-beam emitting device 10B illustrated in FIG. 6 may be used, or the liquid-cooled heat sink 32C as in the laser-beam emitting device 10C illustrated in FIG. 7 may be used.

In the first embodiment as described above, the alternative embodiments illustrated in FIG. 5 to FIG. 8 and FIG. 11, and the second to sixth embodiments as will be described later, the condenser lens 23 is in a planoconvex shape. However, the condenser lens 23 is satisfactory as long as it concentrates the laser beams that have passed through the collimator lens 22 so as to enter a predetermined position (i.e., the optical input end 13a of the optical fiber 13 in the above embodiments), and the condenser lens 23 may be configured in a different manner. Alternatively, for example, when the condenser lens is in a biconvex shape, the outer surfaces that connect between both sides of the biconvex surfaces may be made parallel to the optical axis in a similar manner to the outer surface 23c. Due to such a configuration, the condenser lens 23 can contact the inner surface 16c of the lens holding slot 16 of the lens holding member 14 across its entire surface. Alternatively, a portion of the lens holding slot (that corresponds to the back end surface 16d) of the lens holding member 14 may be shaped like a convex surface such that the condenser lens contacts the lens holding slot across its entire surface. Further, in the first embodiment as described above and the alternative embodiments illustrated in FIG. 5 to FIG. 8, the condenser lens 23 is made of a glass material. However, the condenser lens 23 is satisfactory as long as it concentrates the laser beams that have passed through the collimator lens 22 so as to enter a predetermined position (i.e., the optical input end 13a of the optical fiber 13 in the above embodiments), and the condenser lens 23 may be made of a resin material or other kinds of material. No limitation is intended by the configuration of the embodiments as described above.

In the first embodiment as described above, the alternative embodiments illustrated in FIG. 5, FIG. 7, and FIG. 8, and the second and third embodiments as will be described later, the Peltier element 31 that serves as a thermionic element is used as the cooler 30. However, such a thermionic element may be disposed as desired in view of the temperature required for the laser array chip 21 (i.e., the laser-beam source unit), the temperature of the ambient atmosphere, the cooling capability of the heat sink 32 (heat-dissipating member) and the air-blowing fan 33 (air-blowing mechanism). No limitation is intended by the configuration of the embodiments as described above. The thermionic element is satisfactory as long as it is disposed between the laser-beam source unit (i.e., the laser array chip 21) and the heat-dissipating member (i.e., the heat sink 32) in order to cool the laser-beam source unit to a temperature lower than the ambient temperature. No limitation is intended by the first embodiment as described above. The same can be said of the air-blowing fan 33 that serves as an air-blowing mechanism of the cooler 30 as in the first embodiment ad described above and the alternative embodiments illustrated in FIG. 5, FIG. 6, and FIG. 8, and same can be said of the exterior component 28 as in the first embodiment ad described above and the alternative embodiments illustrated in FIG. 5 to FIG. 8.

In the first embodiment as described above and the alternative embodiments illustrated in FIG. 5 to FIG. 8, laser beams are used for igniting an internal combustion engine. However, the optical exit end 13b (i.e., the other end) of the optical fiber 13 may be connected to a device that uses laser beams such as a laser beam machine. No limitation is intended by the first embodiment as described above.

### Second Embodiment

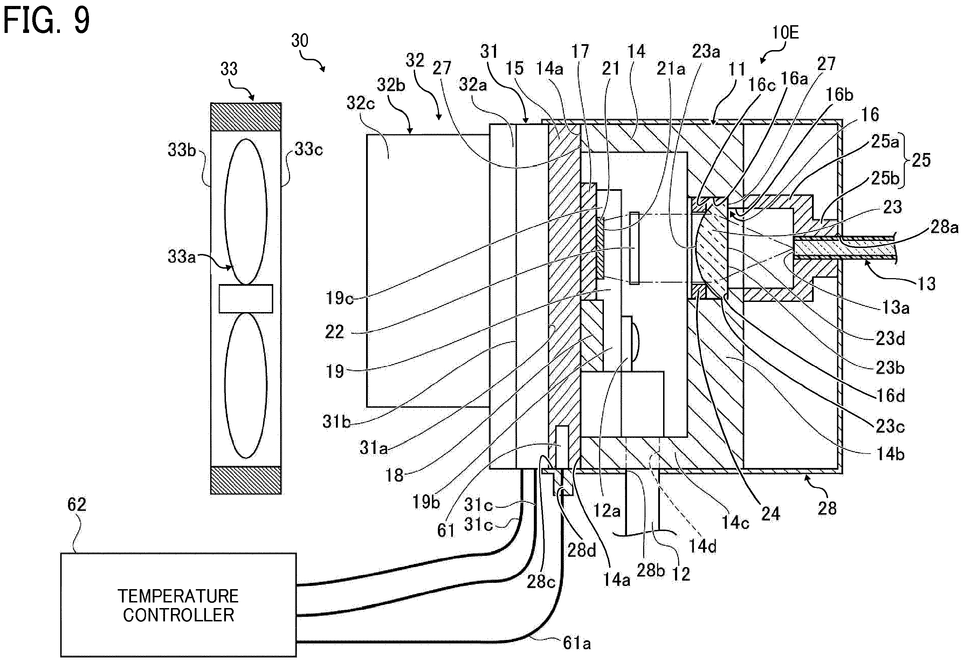

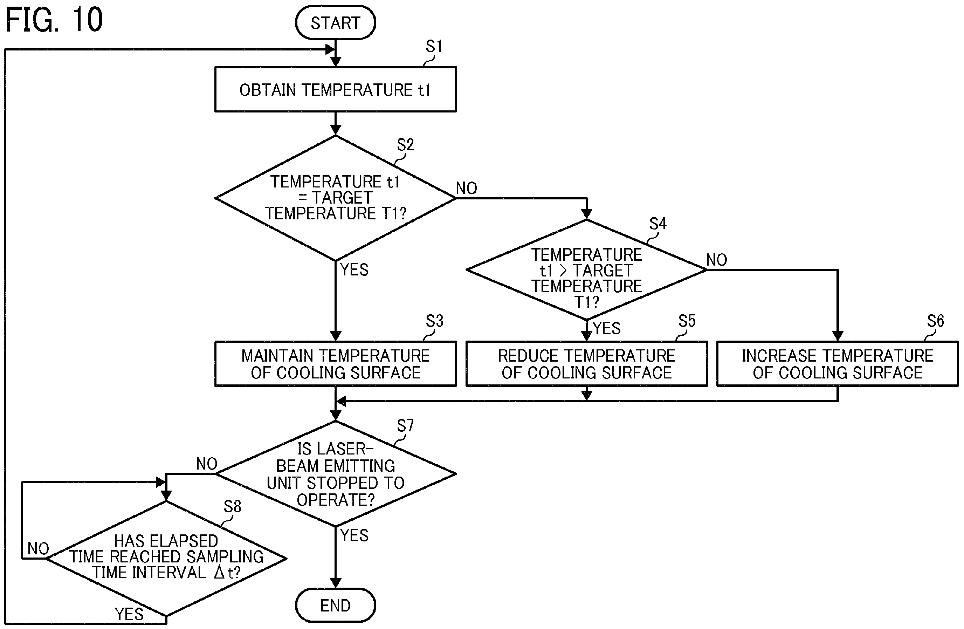

Next, a laser-beam emitting device 10E according to a second embodiment of the present disclosure is described with reference to FIG. 9 and FIG. 10. In the laser-beam emitting device 10E, some of the configuration is different from the laser-beam emitting device 10 according to the first embodiment. As the basic concepts, configuration, and the effects of the laser-beam emitting device 10E are similar to those of the laser-beam emitting device 10 according to the first embodiment illustrated in FIG. 1 to FIG. 4, like reference signs denote like elements and a detailed description is omitted.

In the laser-beam emitting device 10E according to the second embodiment, the cooler 30 can cool the laser-beam source unit (i.e., the laser array chip 21) and the condenser lens 23 more precisely compared with the first embodiment. As illustrated in FIG. 9, the laser-beam emitting device 10E includes a thermistor 61 and a temperature controller 62. The thermistor 61 is an example of a temperature detector that detects the temperature of a laser output device that outputs laser beams in the laser-beam emitting device 10E, i.e., for example, the temperature of the laser-beam source unit (i.e., the laser array chip 21), the thermal diffusion board 15 on which the laser-beam source unit is mounted, the condenser lens 23, and the lens holding member 14. In the second embodiment, the thermistor 61 is disposed to detect a temperature t1 of the thermal diffusion board 15 of the laser output device, and sends to the temperature controller 62 the signal of the temperature t1 detected through a detection line 61a connected to the thermistor 61 itself. According to this configuration, a detection slot 28d through which the detection line 61a passes through is formed on the exterior component 28.

The temperature controller 62 is disposed to adjust the amount of heat dissipation at the heat-dissipating unit of the cooler 30 (including the heat-dissipative surface 31b of the Peltier element 31 (thermionic element), the heat sink 32, and the air-blowing fan 33 (air-blowing mechanism)). The temperature controller 62 according to the second embodiment is to control the temperature of the Peltier element 31. The power lines 31c of the Peltier element 31 are connected to the temperature controller 62, and the detection line 61a of the thermistor 61 is connected to the temperature controller 62. The temperature controller 62 adjusts the temperature of the cooling surface 31a that is applied to the thermal diffusion board 15, based on the temperature t1 detected by the thermistor 61, such that the temperature of the thermal diffusion board 15 will become a predetermined target temperature T1. In other words, when the temperature t1 is higher than the target temperature T1, the temperature controller 62 determines that the cooling is insufficient and reduces the temperature of the cooling surface 31a. When the temperature t1 is lower than the target temperature T1, the temperature controller 62 determines that the cooling is excessive and increases the temperature of the cooling surface 31a (i.e., attenuate the cooling). In so doing, the temperature of the cooling surface 31a may be adjusted according to a difference between the temperature t1 and the target temperature T1, or the temperature of the cooling surface 31a may be adjusted to a predetermined temperature regardless of such a difference. In the first embodiment, the temperature of the cooling surface 31a is adjusted by controlling, for example, the values of the current that is supplied through the power lines 31c. The target temperature T1 may be a single value, or may have a predetermined range.

Next, temperature control processes where the temperature controller 62 controls the temperature of the Peltier element 31 to control the cooling temperature in the laser-beam emitting device 10E according to the second embodiment are described with reference to FIG. 10. Such temperature control processes are performed by the temperature controller 62 based on a program stored in a built-in memory. The steps of the flowchart illustrated in FIG. 10 are described as below. The steps in the flowchart of FIG. 10 start when the laser-beam emitting device 10E is driven and the temperature controller 62 starts controlling the Peltier element 31 such that the temperature difference between the cooling surface 31a and the heat-dissipative surface 31b becomes equal to a predetermined temperature difference.

In a step S1, temperature t1 is obtained from the thermistor 61, and the process proceeds to a step S2.

In the step S2, whether or not the temperature t1 is equal to a target temperature T1 is determined. When it is determined to be "YES" in the step S2, the process proceeds to a step S3. When it is determined to be "NO" in the step S2, the process proceeds to a step S4. In the step S2, when the target temperature T1 has a predetermined range, whether or not the temperature t1 is within the target temperature T1 is determined.

In a step S3, the temperature of the cooling surface 31a is maintained, and the process proceeds to a step S7. As the temperature t1 is equal to the target temperature T1 in the step S3, the temperature of the cooling surface 31a of the Peltier element 31 at that point in time is maintained.

In a step S4, whether or not the temperature t1 is higher than the target temperature T1 is determined. When it is determined to be "YES" in the step S4, the process proceeds to a step S5. When it is determined to be "NO" in the step S4, the process proceeds to a step S6.

In the step S5, the temperature of the cooling surface 31a is reduced, and the process proceeds to a step S7. In the step S5, the temperature of the cooling surface 31a is reduced such that the temperature of the thermal diffusion board 15 will be equal to the target temperature T1.

In the step S6, the temperature of the cooling surface 31a is increased, and the process proceeds to the step S7. In the step S6, the temperature of the cooling surface 31a is increased such that the temperature of the thermal diffusion board 15 will be equal to the target temperature T1.

In the step S7, whether or not the laser-beam emitting device 10E is stopped is determined. When it is determined to be "YES" in the step S7, this temperature control process is terminated. When it is determined to be "NO" in the step S7, the process proceeds to a step S8. In the step S7, whether or not the laser-beam emitting device 10E is stopped, i.e., whether it is no longer necessary to cool down the laser-beam source unit (i.e., the laser array chip 21) using the cooler 30 is determined.

In the step S8, whether the elapsed time has reached the sampling time interval Δt is determined. When it is determined to be "YES" in the step S8, the process returns to the step S1. When it is determined to be "NO" in the step S8, the process in the step S8 is repeated. In the step S8, the temperature controller 62 goes on standby until the time elapsed since the temperature t1 was obtained in the step S1 reaches a sampling time interval Δt, and when the elapsed time reaches the sampling time interval Δt, the process returns to the step S1.

Once the laser-beam emitting device 10E is driven, the cooler 30 starts cooling the laser-beam source unit (i.e., the laser array chip 21). In parallel with that, the temperature controller 62 performs temperature control processes as depicted in the flowchart of FIG. 10 to adjust the temperature of the cooling surface 31a of the Peltier element 31 based on the temperature t1 detected by the thermistor 61, such that the temperature of the thermal diffusion board 15 will be close to the target temperature T1. Accordingly, the cooler 30 can consistently control the temperature of the thermal diffusion board 15 to be close to the target temperature T1, and the laser-beam source unit (i.e., the laser array chip 21) can more appropriately be cooled. Moreover, the condenser lens 23 can more appropriately be cooled through the lens holding member 14.

As the configuration of the laser-beam emitting device 10E according to the second embodiment is basically similar to that of the laser-beam emitting device 10 according to the first embodiment, basically, effects similar to those achieved by the first embodiment can be achieved in the laser-beam emitting device 10E.

Furthermore, in the laser-beam emitting device 10E according to the present embodiment, the temperature controller 62 adjusts the temperature of the cooling surface 31a of the Peltier element 31 based on the temperature t1 detected by the thermistor 61, such that the temperature of the thermal diffusion board 15 will be close to the target temperature T1. Accordingly, the laser-beam source unit (i.e., the laser array chip 21) and the condenser lens 23 can more appropriately be cooled.

Accordingly, in the laser-beam emitting device 10E according to the second embodiment of the present disclosure, even when the condenser lens 23 concentrates high-power laser beams, the temperature of the condenser lens 23 can be prevented from increasing.

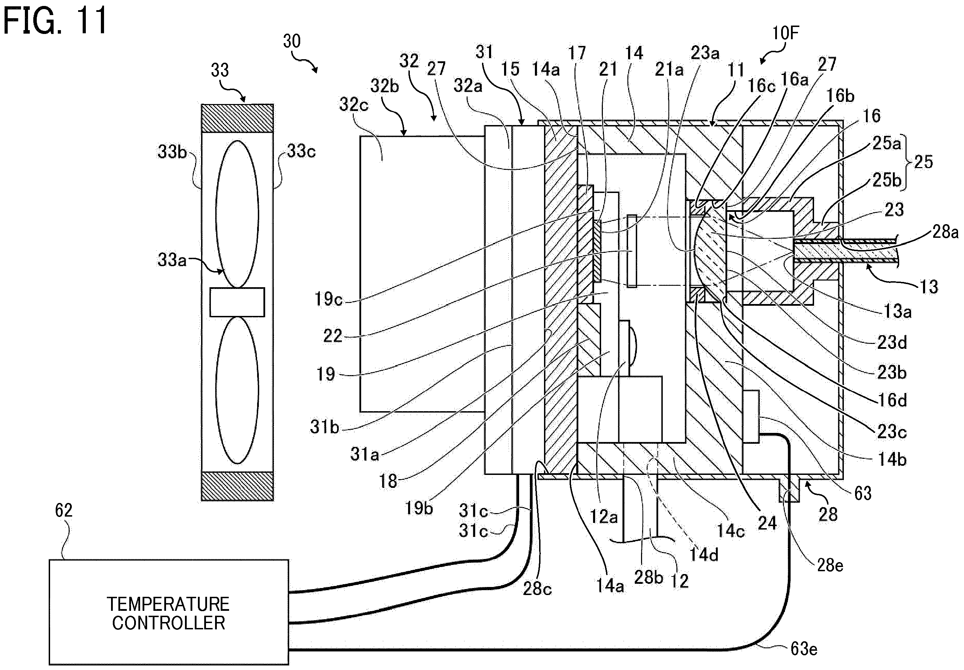

In the second embodiment as described above, the temperature of the cooling surface 31a of the Peltier element 31 is controlled based on the temperature t1 of the thermal diffusion board 15 detected by the thermistor 61. However, a laser-beam emitting device 10F as illustrated in FIG. 11 may be adopted. In the laser-beam emitting device 10F according to the present alternative embodiment, a thermistor 63 is disposed to detect a temperature t2 of the lens holding member 14 of the laser output device. According to this configuration, a detection slot 28e through which the detection line 63a of the thermistor 63 passes through is formed on the exterior component 28 in place of the detection slot 28d. In the laser-beam emitting device 10F according to the present alternative embodiment, the temperature controller 62F adjusts the temperature of the cooling surface 31a of the Peltier element 31 based on a temperature t2 detected by the thermistor 63, such that the temperature of the lens holding member 14 will be close to a predetermined target temperature T2. As the configuration of the laser-beam emitting device 10F is basically similar to that of the laser-beam emitting device 10E according to the second embodiment, basically, effects similar to those achieved by the second embodiment can be achieved in the laser-beam emitting device 10F. Furthermore, in the laser-beam emitting device 10F according to the present alternative embodiment, the temperature of the cooling surface 31a is adjusted such that the temperature of the lens holding member 14 will be close to the target temperature T2. Accordingly, the condenser lens 23 can more appropriately be cooled.

### Third Embodiment

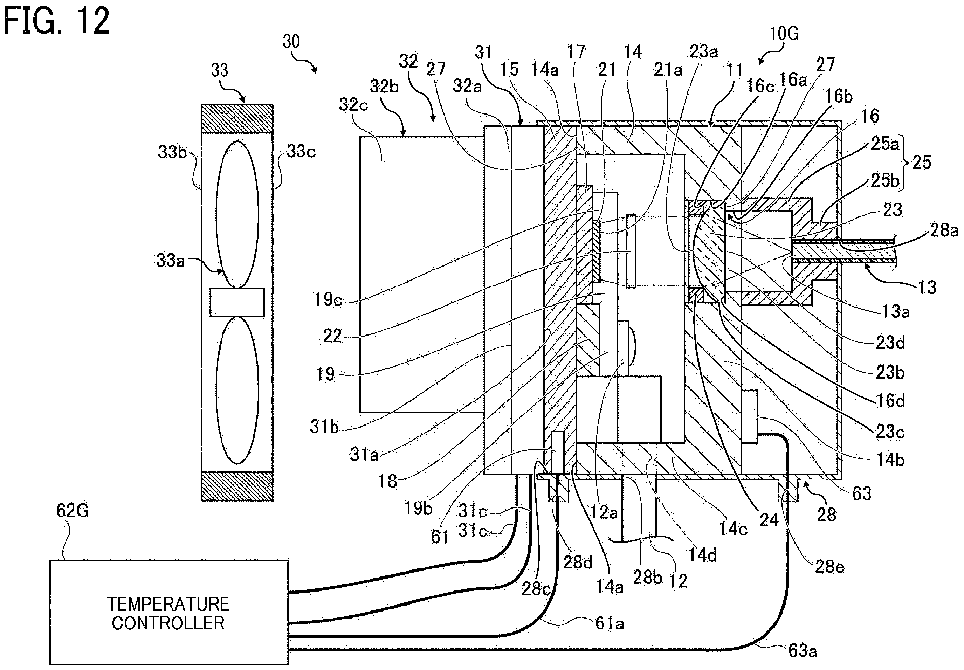

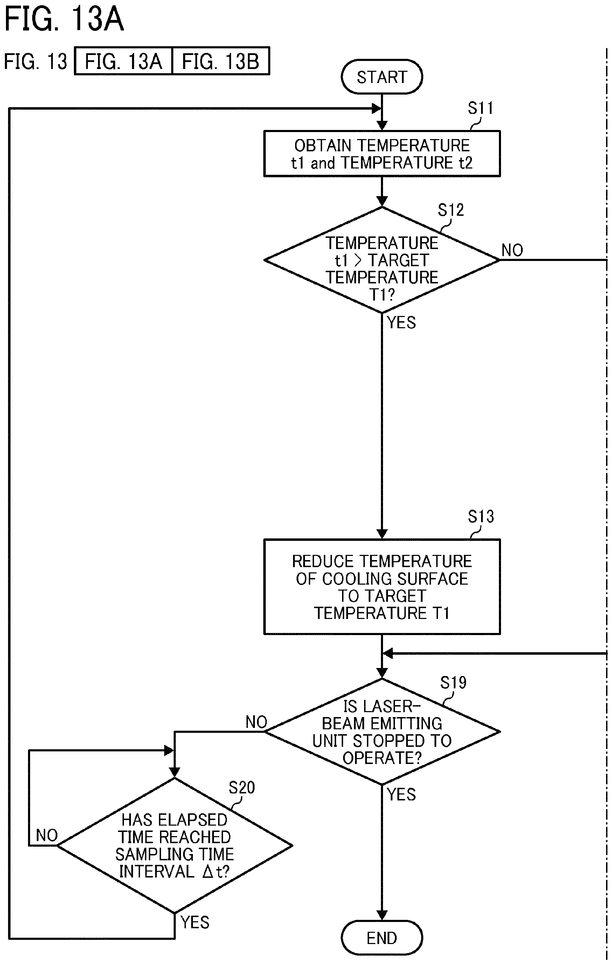

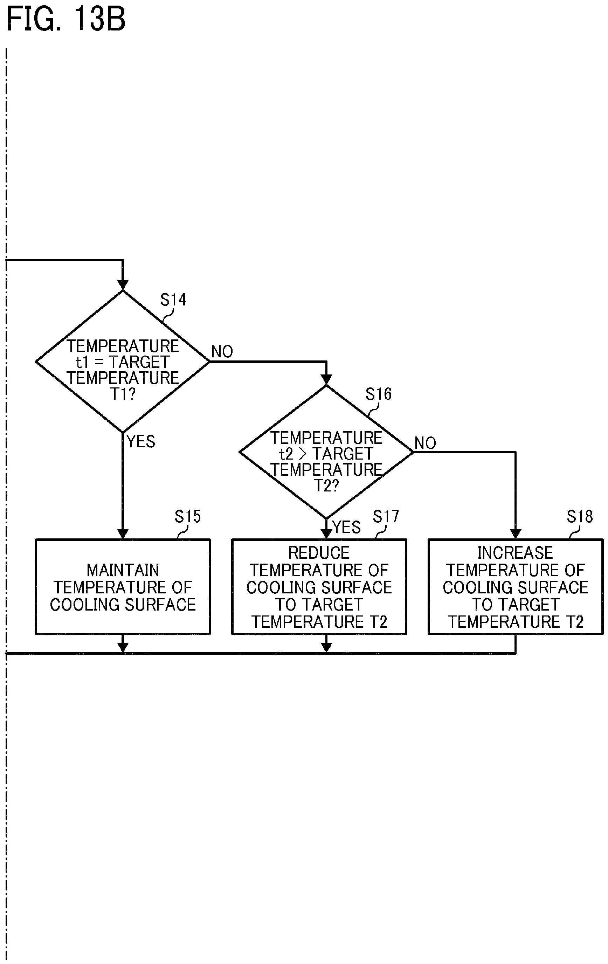

Next, a laser-beam emitting device 10G according to a third embodiment of the present disclosure is described with reference to FIG. 12, FIG. 13A, and FIG. 13B. In the laser-beam emitting device 10G, some of the configuration is different from the laser-beam emitting device 10 according to the first embodiment. As the basic concepts, configuration, and the effects of the laser-beam emitting device 10G are similar to those of the laser-beam emitting device 10 according to the first embodiment illustrated in FIG. 1 to FIG. 4, like reference signs denote like elements, and the detailed description is omitted.

In the laser-beam emitting device 10G according to the third embodiment, under concepts similar to those of the laser-beam emitting device 10E according to the second embodiment, the cooler 30 can cool the laser-beam source unit (i.e., the laser array chip 21) and the condenser lens 23 more precisely compared with the first embodiment. As illustrated in FIG. 12, the laser-beam emitting device 10G includes the thermistor 61, the thermistor 63, and a temperature controller 62G. The thermistor 61 is similar to that of the second embodiment illustrated in FIG. 9, and the thermistor 63 is similar to that of the alternative embodiment of the second embodiment illustrated in FIG. 11.

The temperature controller 62G is basically similar to that of the second embodiment illustrated in FIG. 9 and FIG. 11, and the detection line 61a of the thermistor 61 and the detection line 63a of the thermistor 63 are connected to the temperature controller 62G. Under normal operating conditions where the temperature of the thermal diffusion board 15 is close to a predetermined target temperature T1, the temperature controller 62G adjusts the temperature of the cooling surface 31a such that the temperature of the lens holding member 14 will be close to a predetermined target temperature T2. When the temperature of the thermal diffusion board 15 is higher than the target temperature T1, the temperature controller 62G switches the control to adjust the temperature of the cooling surface 31a such that the temperature of the thermal diffusion board 15 will be close to the target temperature T1.

In other words, under normal operating conditions, the temperature controller 62G operates in a similar manner to the laser-beam emitting device 10F illustrated in FIG. 11, and when the temperature of the thermal diffusion board 15 is higher than a desired temperature, the temperature controller 62G operates in a similar manner to the laser-beam emitting device 10E illustrated in FIG. 9. In so doing, the temperature of the cooling surface 31a may be adjusted according to differences between the detected temperatures (t1, t2) and the target temperatures (T1, T2), or the temperature of the cooling surface 31a may be adjusted to a predetermined temperature regardless of such a difference. For example, the temperature of the thermal diffusion board 15 may become higher than a desired temperature when the amount of heat increases due to an increase in electrical resistance caused by the age deterioration of the electric circuit. Due to the configuration as described above, the temperature controller 62G can prevent a malfunction or a fast-paced reduction in useful life that are caused when the laser-beam source unit (i.e., the laser array chip 21) gets too hot.

Next, temperature control processes where the temperature controller 62G controls the temperature of the Peltier element 31 to control the cooling temperature in the laser-beam emitting device 10G according to the third embodiment are described with reference to FIG. 13A and FIG. 13B. The temperature control processes that are performed by the temperature controller 62G are basically similar to the temperature control processes depicted in the flowchart of FIG. 10, and the temperature controller 62G performs such temperature control processes based on a program stored in a built-in memory. The steps of the flowchart illustrated in FIG. 13A and FIG. 13B are described as below.

In a step S11, temperature t1 and temperature t2 are obtained from the thermistor 61 and the thermistor 63, respectively, and the process proceeds to a step S12.

In the step S12, whether or not the temperature t1 is higher than the target temperature T1 is determined. When it is determined to be "YES" in the step S12, the process proceeds to a step S13. When it is determined to be "NO" in the step S12, the process proceeds to a step S14.

In the step S13, the temperature of the cooling surface 31a is reduced to the target temperature T1, and the process proceeds to a step S19. In the step S13, the temperature of the cooling surface 31a is reduced such that the temperature of the thermal diffusion board 15 will be close to the target temperature T1.

In the step S14, whether or not the temperature t1 is equal to the target temperature T1 is determined. When it is determined to be "YES" in the step S14, the process proceeds to a step S15. When it is determined to be "NO" in the step S14, the process proceeds to a step S16.

In the step S15, the temperature of the cooling surface 31a is maintained, and the process proceeds to a step S19.

In the step S16, whether or not the temperature t2 is higher than the target temperature T2 is determined. When it is determined to be "YES" in the step S16, the process proceeds to a step S17. When it is determined to be "NO" in the step S16, the process proceeds to a step S18.

In the step S17, the temperature of the cooling surface 31a is reduced to the target temperature T2, and the process proceeds to a step S19. In the step S17, the temperature of the cooling surface 31a is reduced such that the temperature of the lens holding member 14 will be close to the target temperature T2.

In the step S18, the temperature of the cooling surface 31a is increased to the target temperature T2, and the process proceeds to a step S19. In the step S18, the temperature of the cooling surface 31a is increased such that the temperature of the lens holding member 14 will be close to the target temperature T2.

In the step S19, whether or not the laser-beam emitting device 10G is stopped is determined. When it is determined to be "YES" in the step S19, this temperature control process is terminated. When it is determined to be "NO" in the step S19, the process proceeds to a step S20.

In the step S20, whether the elapsed time has reached the sampling time interval Δt is determined. When it is determined to be "YES" in the step S20, the process returns to the step S11. When it is determined to be "NO" in the step S20, the process in the step S20 is repeated.

Once the laser-beam emitting device 10G is driven, the cooler 30 starts cooling the laser-beam source unit (i.e., the laser array chip 21). In parallel with that, the temperature controller 62G performs temperature control processes as depicted in the flowchart of FIG. 13A and FIG. 13B, and when the temperature t1 of the thermal diffusion board 15 is lower than the target temperature T1, the temperature controller 62G adjusts the temperature of the cooling surface 31a based on the temperature t2 detected by the thermistor 63, such that the temperature of the lens holding member 14 will be close to the predetermined target temperature T2. When the temperature t1 of the thermal diffusion board 15 becomes higher than the target temperature T1 due to the performed temperature control processes, the temperature controller 62G
reduces the temperature of the cooling surface 31a such that the temperature of the thermal diffusion board 15 will be close to the target temperature T1. Accordingly, under normal operating conditions, the cooler 30 can consistently control the temperature of the lens holding member 14 to be close to the target temperature T2, and the temperature of the thermal diffusion board 15 can be made lower than the target temperature T1. Accordingly, the laser-beam source unit (i.e., the laser array chip 21) and the condenser lens 23 can more appropriately be cooled.

As the configuration of the laser-beam emitting device 10G according to the third embodiment is basically similar to that of the laser-beam emitting device 10 according to the first embodiment, basically, effects similar to those achieved by the first embodiment can be achieved in the laser-beam emitting device 10G.

Furthermore, in the laser-beam emitting device 10G according to the present embodiment, the temperature of the thermal diffusion board 15 is made lower than the target temperature T1, and the temperature of the cooling surface 31a of the Peltier element 31 is adjusted such that the temperature of the lens holding member 14 will be close to the target temperature T2. Accordingly, the laser-beam source unit (i.e., the laser array chip 21) and the condenser lens 23 can more appropriately be cooled.

Accordingly, in the laser-beam emitting device 10G according to the third embodiment of the present disclosure, even when the condenser lens 23 concentrates high-power laser beams, the temperature of the condenser lens 23 can be prevented from increasing.

In the second embodiment and the third embodiment of the present disclosure, the thermistor 61 or the thermistor 63 is provided for the laser-beam emitting device 10 illustrated in FIG. 3. However, the thermistor 61 or the thermistor 63 may be provided for the laser-beam emitting device 10A illustrated in FIG. 5 or the laser-beam emitting device 10D illustrated in FIG. 8, and no limitation is intended by the configurations of the second embodiment and the third embodiment.

### Fourth Embodiment

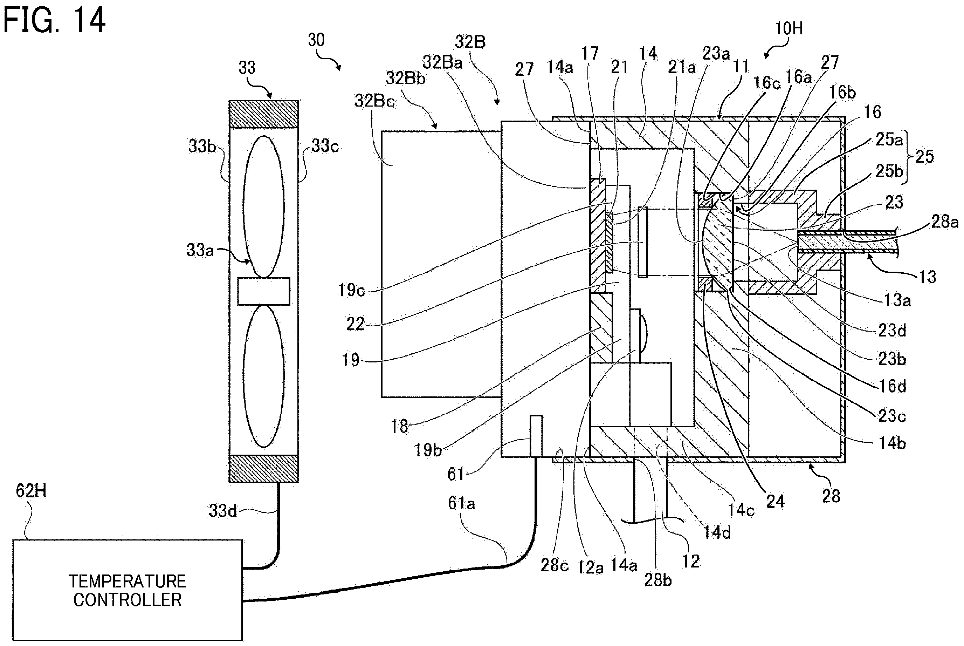

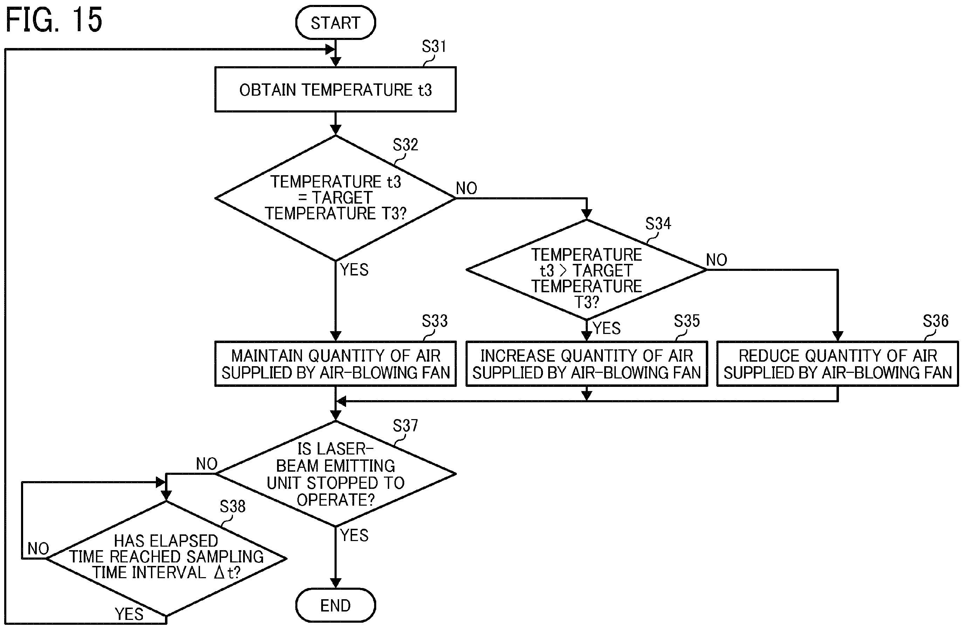

Next, a laser-beam emitting device 10H according to a fourth embodiment of the present disclosure is described with reference to FIG. 14 and FIG. 15. In the laser-beam emitting device 10H, the thermistor 61 and the temperature controller 62H are provided for the laser-beam emitting device 10B illustrated in FIG. 6. As the basic concepts, configuration, and the effects of the laser-beam emitting device 10H are similar to those of the laser-beam emitting device 10B illustrated in FIG. 6, like reference signs denote like elements, and the detailed description is omitted.

In the laser-beam emitting device 10H according to the fourth embodiment, under concepts similar to those of the laser-beam emitting device 10E according to the second embodiment, the cooler 30 can cool the laser-beam source unit (i.e., the laser array chip 21) and the condenser lens 23 more precisely compared with the laser-beam emitting device 10B illustrated in FIG. 6. As illustrated in FIG. 14, the laser-beam emitting device 10H includes the thermistor 61 and the temperature controller 62H in a similar manner to the second embodiment. Note also that the thermistor 61 is an example of a temperature detector that detects a temperature t3 of the endothermic part 32Ba of the heat sink 32B of the laser output device, and sends the detected temperature t3 to the temperature controller 62H through the detection line 61a.

The temperature controller 62H controls the volume of air (number of revolutions) of the air-blowing fan 33 (air-blowing mechanism) of the heat-dissipating unit of the cooler 30. A power line 33d of the air-blowing fan 33 is connected to the temperature controller 62H, and the detection line 61a of the thermistor 61 is connected to the temperature controller 62H. The temperature controller 62H adjusts the volume of air of the air-blowing fan 33 based on the temperature t3 detected by the thermistor 61, such that the temperature of the endothermic part 32Ba will be close to a predetermined target temperature T3. In other words, the temperature controller 62 increases the volume of air that is blown from the air-blowing fan 33 when the temperature t3 is higher than the target temperature T3, and decreases the volume of air that is blown from the air-blowing fan 33 when the temperature t3 is lower than the target temperature T3. In so doing, the volume of air that is blown from the air-blowing fan 33 may be adjusted according to a difference between the temperature t3 and the target temperature T3, or the volume of air that is blown from the air-blowing fan 33 may be adjusted to a predetermined volume of air regardless of such a difference. The target temperature T3 may be a single value, or may have a predetermined range.

Next, temperature control processes where the temperature controller 62H controls the volume of air of the air-blowing fan 33 to control the cooling temperature in the laser-beam emitting device 10H according to the fourth embodiment are described with reference to FIG. 15. The temperature control processes that are performed by the temperature controller 62H are basically similar to the temperature control processes depicted in the flowchart of FIG. 10, and such temperature control processes are performed by the temperature controller 62H based on a program stored in a built-in memory. The steps of the flowchart illustrated in FIG. 15 are described as below.

In the step S31, temperature t3 is obtained from the thermistor 61, and the process proceeds to a step S32.

In the step S32, whether or not the temperature t3 is equal to a target temperature T3 is determined. When it is determined to be "YES" in the step S32, the process proceeds to a step S33. When it is determined to be "NO" in the step S32, the process proceeds to a step S34.

In the step S33, the quantity of air supplied by the air-blowing fan 33 is maintained, and the process proceeds to a step S37.

In the step S34, whether or not the temperature t3 is higher than the target temperature T3 is determined. When it is determined to be "YES" in the step S34, the process proceeds to a step S35. When it is determined to be "NO" in the step S34, the process proceeds to a step S3 6.

In the step S35, the volume of air at the air-blowing fan 33 is increased, and the process proceeds to a step S37.

In the step S36, the volume of air at the air-blowing fan 33 is reduced, and the process proceeds to a step S37.

In the step S37, whether or not the laser-beam emitting device 10H is stopped is determined. When it is determined to be "YES" in the step S37, this temperature control process is terminated. When it is determined to be "NO" in the step S37, the process proceeds to a step S38.

In the step S38, whether the elapsed time has reached the sampling time interval Δt is determined. When it is determined to be "YES" in the step S38, the process returns to the step S31. When it is determined to be "NO" in the step S38, the process in the step S38 is repeated.

Once the laser-beam emitting device 10H is driven, the cooler 30 starts cooling the laser-beam source unit (i.e., the laser array chip 21). In parallel with that, the temperature controller 62H performs temperature control processes as depicted in the flowchart of FIG. 15 to adjust the volume of air of the air-blowing fan 33 based on the temperature t3 detected by the thermistor 61, such that the temperature of the endothermic part 32Ba of the heat sink 32B will be close to the target temperature T3. Accordingly, the cooler 30 can consistently control the temperature of the endothermic part 32Ba to be close to the target temperature T3, and
Accordingly, the laser-beam source unit (i.e., the laser array chip 21) and the condenser lens 23 can more appropriately be cooled.

As the configuration of the laser-beam emitting device 10H according to the fourth embodiment is basically similar to that of the laser-beam emitting device 10B illustrated in FIG. 6, basically, effects similar to those achieved by the laser-beam emitting device 10B illustrated in FIG. 6 can be achieved in the laser-beam emitting device 10H.

Furthermore, in the laser-beam emitting device 10H according to the present embodiment, adjusts the volume of air of the air-blowing fan 33 such that the temperature of the endothermic part 32Ba will be close to the target temperature T3. Accordingly, the laser-beam source unit (i.e., the laser array chip 21) and the condenser lens 23 can more appropriately be cooled.

Accordingly, in the laser-beam emitting device 10H according to the fourth embodiment of the present disclosure, even when the condenser lens 23 concentrates high-power laser beams, the temperature of the condenser lens 23 can be prevented from increasing.

In the fourth embodiment, the thermistor 61 is provided only for the endothermic part 32Ba. However, as illustrated in FIG. 11, the thermistor 63 may be provided only for the lens holding member 14, or the thermistor 61 and the thermistor 63 may be arranged as in the third embodiment. No limitation is intended by the configuration of the fourth embodiment.

### Fifth Embodiment

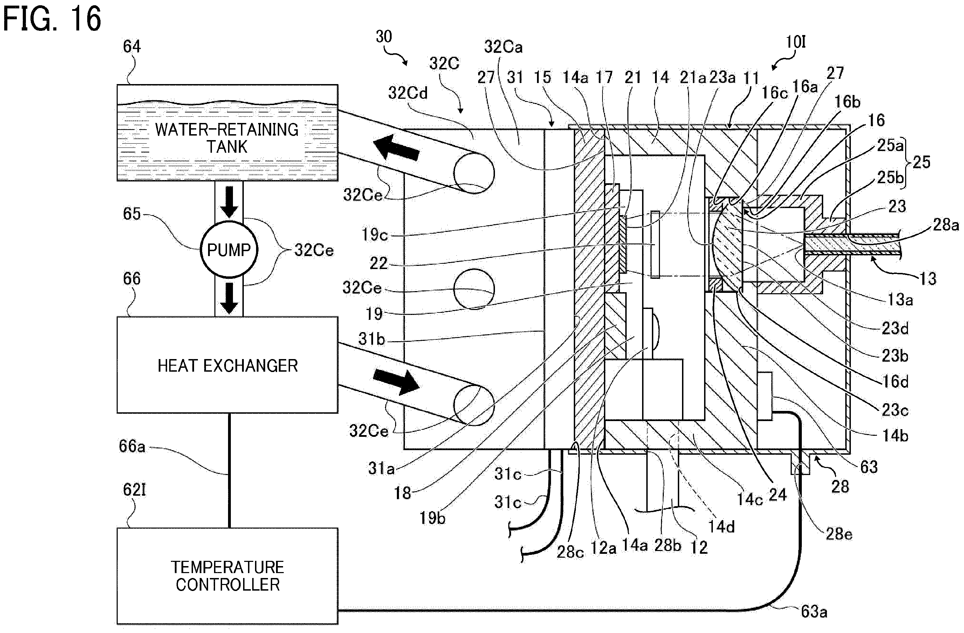

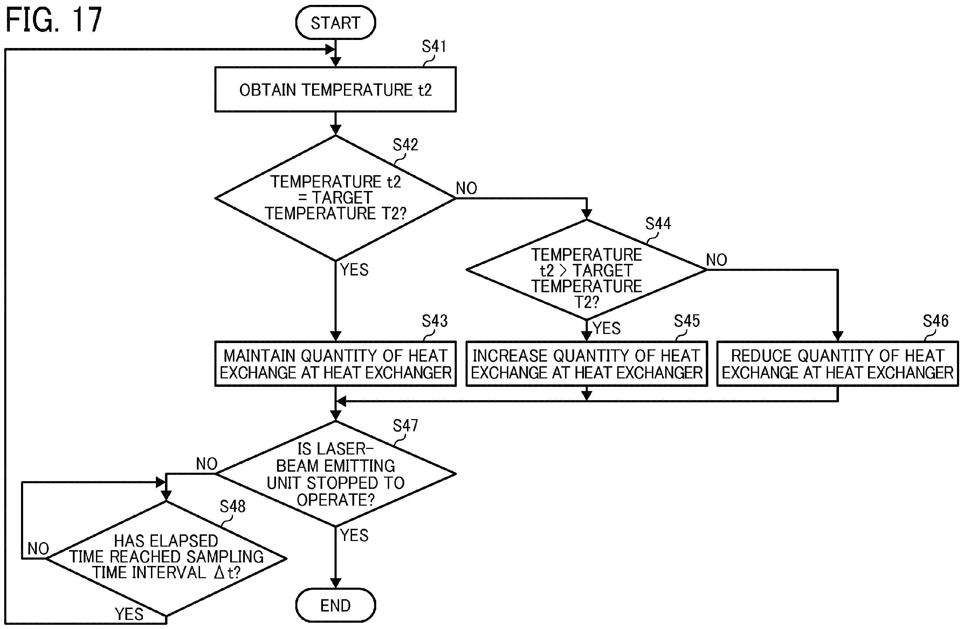

Next, a laser-beam emitting device 10I according to a fifth embodiment of the present disclosure is described with reference to FIG. 16 and FIG. 17. In the laser-beam emitting device 10I, the thermistor 63 and the temperature controller 62I are provided for the laser-beam emitting device 10C illustrated in FIG. 7. As the basic concepts, configuration, and the effects of the laser-beam emitting device 10I are similar to those of the laser-beam emitting device 10C illustrated in FIG. 7, like reference signs denote like elements and a detailed description is omitted.

In the laser-beam emitting device 10I according to the fifth embodiment, under concepts similar to those of the laser-beam emitting device 10E according to the second embodiment, the cooler 30 can cool the laser-beam source unit (i.e., the laser array chip 21) and the condenser lens 23 more precisely compared with the laser-beam emitting device 10C illustrated in FIG. 7. First of all, as illustrated in FIG. 16, in the laser-beam emitting device 10I, the coolant channel 32Ce of the liquid-cooled heat sink 32C is provided with a water-retaining tank 64, a pump 65, and a heat exchanger 66. As the pump 65 is driven, the cooling water that is stored in the water-retaining tank 64 is sent to the heat exchanger 66 through the coolant channel 32Ce, and the cooling water that has been cooled by the heat exchanger 66 is supplied to the heat sink 32C. Then, the temperature of the cooling water is risen by heat exchange at the heat sink 32C, and the cooling water whose temperature is risen is stored in the water-retaining tank 64. Accordingly, in the laser-beam emitting device 10I, the coolant channel 32Ce, the water-retaining tank 64, the pump 65, and the heat exchanger 66 together serve as a heat-dissipating unit of the cooler 30.

The laser-beam emitting device 10I includes the thermistor 63 and the temperature controller 62I in a similar manner to the second embodiment. The thermistor 63 is an example of a temperature detector that detects the temperature t2 of the lens holding member 14 of the laser output device, and sends the detected temperature t2 to the temperature controller 62I through the detection line 63a. According to this configuration, a detection slot 28e through which the detection line 63a passes through is formed on the exterior component 28.

The temperature controller 62I controls the quantity of heat exchange (cooling power) at the heat exchanger 66 of the heat-dissipating unit of the cooler 30. A power line 66a of the heat exchanger 66 is connected to the temperature controller 62I, and the detection line 63a of the thermistor 63 is connected to the temperature controller 62I. The temperature controller 62I adjusts the quantity of heat exchange at the heat exchanger 66 based on the temperature t2 detected by the thermistor 63, such that the temperature of the lens holding member 14 will be close to the predetermined target temperature T2. In other words, when the temperature t2 is higher than the target temperature T2, the temperature controller 62 increases the quantity of heat exchange at the heat exchanger 66 to reduce the temperature of the coolant, and when the temperature t2 is lower than the target temperature T2, the quantity of heat exchange at the heat exchanger 66 is reduced to increase the temperature of the coolant. In so doing, the quantity of heat exchange at the heat exchanger 66 may be adjusted according to a difference between the temperature t2 and the target temperature T2, or the quantity of heat exchange at the heat exchanger 66 may be adjusted to a predetermined quantity of heat exchange regardless of such a difference.

Next, temperature control processes where the temperature controller 62I controls the quantity of heat exchange at the heat exchanger 66 to control the cooling temperature in the laser-beam emitting device 10I according to the fifth embodiment are described with reference to FIG. 17. The temperature control processes that are performed by the temperature controller 62I are basically similar to the temperature control processes depicted in the flowchart of FIG. 10, and such temperature control processes are performed by the temperature controller 62I based on a program stored in a built-in memory. The steps of the flowchart illustrated in FIG. 17 are described as below.

In the step S41, temperature t2 is obtained from the thermistor 63, and the process proceeds to a step S42.

In the step S42, whether or not the temperature t2 is equal to the target temperature T2 is determined. When it is determined to be "YES" in the step S42, the process proceeds to a step S43. When it is determined to be "NO" in the step S42, the process proceeds to a step S44.

In the step S43, the quantity of heat exchange at the heat exchanger 66 is maintained, and the process proceeds to a step S47.

In the step S44, whether or not the temperature t2 is higher than the target temperature T2 is determined. When it is determined to be "YES" in the step S44, the process proceeds to a step S45. When it is determined to be "NO" in the step S44, the process proceeds to a step S46.

In the step S45, the quantity of heat exchange at the heat exchanger 66 is increased, and the process proceeds to the step S47.

In the step S46, the quantity of heat exchange at the heat exchanger 66 is reduced, and the process proceeds to the step S47.

In the step S47, whether or not the laser-beam emitting device 10I is stopped is determined. When it is determined to be "YES" in the step S47, this temperature control process is terminated. When it is determined to be "NO" in the step S47, the process proceeds to a step S48.

In the step S48, whether the elapsed time has reached the sampling time interval Δt is determined. When it is determined to be "YES" in the step S48, the process returns to the step S41. When it is determined to be "NO" in the step S48, the process in the step S48 is repeated.

Once the laser-beam emitting device 10I is driven, the cooler 30 starts cooling the laser-beam source unit (i.e., the laser array chip 21). In parallel with that, the temperature controller 62I performs temperature control processes as depicted in the flowchart of FIG. 17 to adjust the quantity of heat exchange at the heat exchanger 66 based on the temperature t2 detected by the thermistor 63, such that the temperature of the lens holding member 14 will be close to the target temperature T2. Accordingly, the cooler 30 can consistently control the temperature of the lens holding member 14 to be close to the target temperature T2, and Accordingly, the laser-beam source unit (i.e., the laser array chip 21) and the condenser lens 23 can more appropriately be cooled.

As the configuration of the laser-beam emitting device 10I according to the fifth embodiment is basically similar to that of the laser-beam emitting device 10C illustrated in FIG. 7, basically, effects similar to those achieved by the laser-beam emitting device 10C illustrated in FIG. 7 can be achieved in the laser-beam emitting device 10I.

Furthermore, in the laser-beam emitting device 10I according to the present embodiment, the quantity of heat exchange at the heat exchanger 66 is adjusted such that the temperature of the lens holding member 14 will be close to the target temperature T2. Accordingly, the laser-beam source unit (i.e., the laser array chip 21) and the condenser lens 23 can more appropriately be cooled.

Accordingly, in the laser-beam emitting device 10I according to the fifth embodiment of the present disclosure, even when the condenser lens 23 concentrates high-power laser beams, the temperature of the condenser lens 23 can be prevented from increasing.

In the fifth embodiment, the thermistor 63 is provided only for the lens holding member 14. However, as in the second embodiment of the present disclosure, the thermistor 61 may be provided only for the thermal diffusion board 15, or the thermistor 61 and the thermistor 63 may be arranged as in the third embodiment. No limitation is intended by the configuration of the fifth embodiment.

### Sixth Embodiment

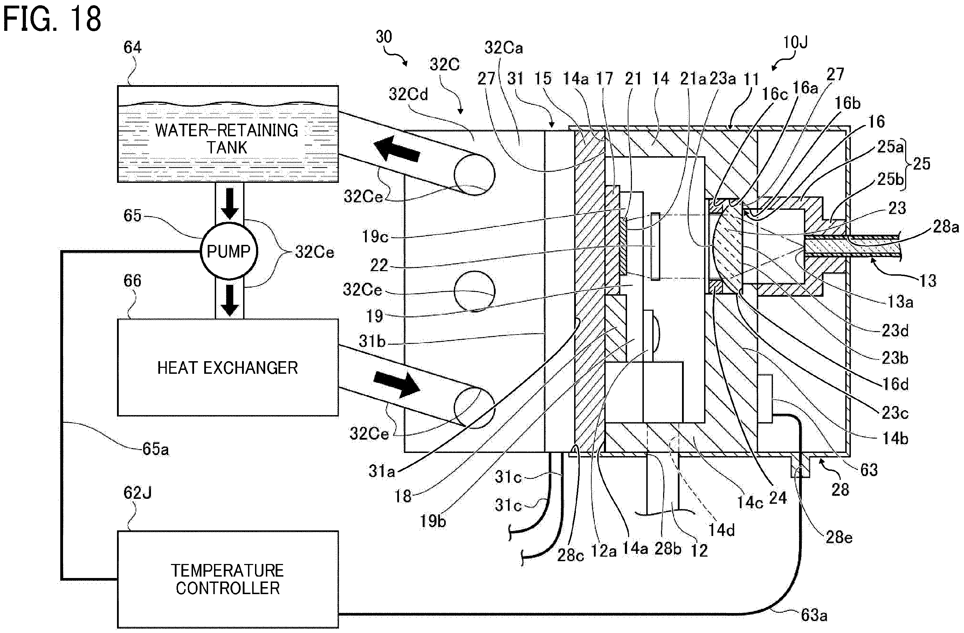

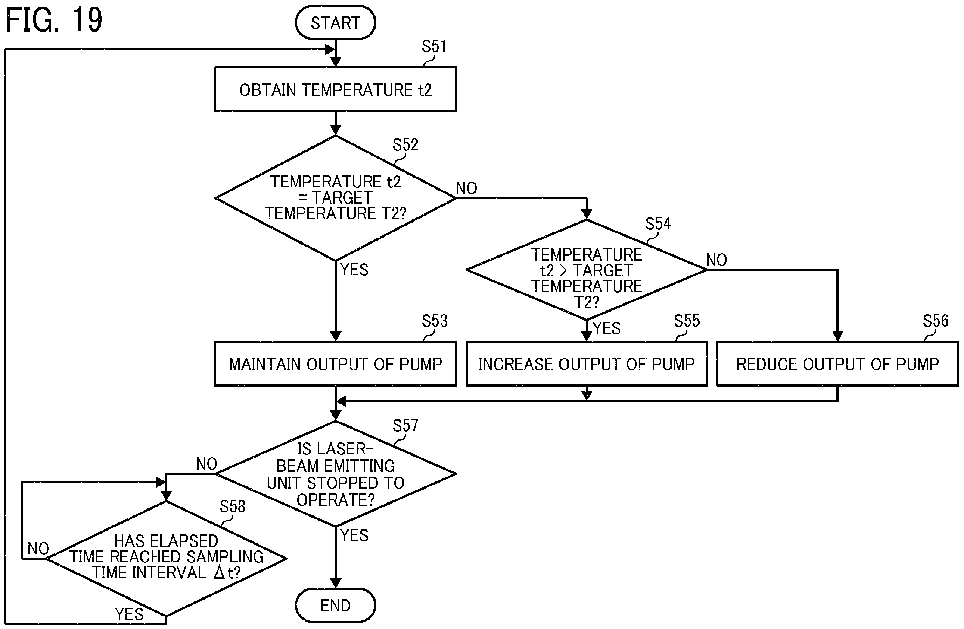

Next, a laser-beam emitting device 10J according to a sixth embodiment of the present disclosure is described with reference to FIG. 18 and FIG. 19. The laser-beam emitting device 10J is an example where the pump 65 is controlled instead of the heat exchanger 66 in the laser-beam emitting device 10J according to the fifth embodiment illustrated in FIG. 16. As the basic concepts, configuration, and the effects of the laser-beam emitting device 10J are similar to those of the laser-beam emitting device 10J according to the fifth embodiment, like reference signs denote like elements, and the detailed description is omitted.

In the laser-beam emitting device 10J according to the sixth embodiment, in a similar manner to the laser-beam emitting device 10I according to the fifth embodiment, the cooler 30 can cool the laser-beam source unit (i.e., the laser array chip 21) and the condenser lens 23 more precisely compared with the laser-beam emitting device 10C illustrated in FIG. 7. A temperature controller 62J of the laser-beam emitting device 10J controls the output power (i.e., the flow rate of the pumped-out cooling water) of the pump 65 of the heat-dissipating unit of the cooler 30. A power line 65a of the pump 65 is connected to the temperature controller 62J, and the detection line 63a of the thermistor 63 is connected to the temperature controller 62J. The temperature controller 62J adjusts the output power of the pump 65 based on the temperature t2 detected by the thermistor 63, such that the temperature of the lens holding member 14 will be close to the predetermined target temperature T2. In other words, the temperature controller 62 increases the output power of the pump 65 to increase the rate of coolant flow when the temperature t2 is higher than the target temperature T2, and the temperature controller 62 reduces the output power of the pump 65 to reduce the rate of coolant flow when the temperature t2 is lower than the target temperature T2. In so doing, the output power of the pump 65 may be adjusted according to a difference between the temperature t2 and the target temperature T2, or the output power of the pump 65 may be adjusted to a predetermined output power regardless of such a difference.

Next, temperature control processes where the temperature controller 62J controls the output power of the pump 65 to control the cooling temperature in the laser-beam emitting device 10J according to the sixth embodiment are described with reference to FIG. 19. The temperature control processes that are performed by the temperature controller 62J are basically similar to the temperature control processes depicted in the flowchart of FIG. 10, and such temperature control processes are performed by the temperature controller 62J based on a program stored in a built-in memory. The steps of the flowchart illustrated in FIG. 19 are described as below.

In the step S51, temperature t2 is obtained from the thermistor 63, and the process proceeds to a step S52.

In the step S52, whether or not the temperature t2 is equal to a target temperature T2 is determined. When it is determined to be "YES" in the step S52, the process proceeds to a step S53. When it is determined to be "NO" in the step S52, the process proceeds to the step S54.

In the step S53, the output of the pump 65 is maintained, and the process proceeds to a step S57.

In the step S54, whether or not the temperature t2 is higher than the target temperature T2 is determined. When it is determined to be "YES" in the step S54, the process proceeds to a step S55. When it is determined to be "NO" in the step S54, the process proceeds to the step S56.

In the step S55, the output of the pump 65 is increased, and the process proceeds to the step S57.

In the step S56, the output of the pump 65 is reduced, and the process proceeds to the step S57.

In the step S57, whether or not the laser-beam emitting device 10J is stopped is determined. When it is determined to be "YES" in the step S57, this temperature control process is terminated. When it is determined to be "NO" in the step S57, the process proceeds to the step S58.

In the step S58, whether the elapsed time has reached the sampling time interval Δt is determined. When it is determined to be "YES" in the step S58, the process returns to the step S51. When it is determined to be "NO" in the step S58, the process in the step S58 is repeated.

Once the laser-beam emitting device 10J is driven, the cooler 30 starts cooling the laser-beam source unit (i.e., the laser array chip 21). In parallel with that, the temperature controller 62J performs temperature control processes as depicted in the flowchart of FIG. 19 to adjust the output power of the pump 65 based on the temperature t2 detected by the thermistor 63, such that the temperature of the lens holding member 14 will be close to the predetermined target temperature T2. Accordingly, the cooler 30 can consistently control the temperature of the lens holding member 14 to be close to the target temperature T2, and Accordingly, the laser-beam source unit (i.e., the laser array chip 21) and the condenser lens 23 can more appropriately be cooled.

As the configuration of the laser-beam emitting device 10J according to the sixth embodiment is basically similar to that of the laser-beam emitting device 10I according to the fifth embodiment, basically, effects similar to those achieved by the fifth embodiment can be achieved in the laser-beam emitting device 10J.

Furthermore, in the laser-beam emitting device 10J according to the present embodiment, the output power of the pump 65 is adjusted such that the temperature of the lens holding member 14 will be close to the target temperature T2. Accordingly, the laser-beam source unit (i.e., the laser array chip 21) and the condenser lens 23 can more appropriately be cooled.

Accordingly, in the laser-beam emitting device 10J according to the sixth embodiment of the present disclosure, even when the condenser lens 23 concentrates high-power laser beams, the temperature of the condenser lens 23 can be prevented from increasing.

In the sixth embodiment, the thermistor 63 is provided only for the lens holding member 14. However, as in the second embodiment of the present disclosure, the thermistor 61 may be provided only for the thermal diffusion board 15, or the thermistor 61 and the thermistor 63 may be arranged as in the third embodiment. No limitation is intended by the configuration of the sixth embodiment.

Numerous additional modifications and variations are possible in light of the above teachings. It is therefore to be understood that within the scope of the appended claims, the present disclosure may be practiced otherwise than as specifically described herein. For example, elements and/or features of different illustrative embodiments may be combined with each other and/or substituted for each other within the scope of this disclosure and appended claims.

## Claims

1. A laser-beam emitting device (10) comprising:
a laser-beam source unit (21) configured to emit a laser beam;
a condenser lens (23) configured to concentrate the laser beam emitted from the laser-beam source unit (21) to a prescribed position;
a holding member (14) configured to contact the condenser lens (23) across its entire surface and hold the condenser lens (23); and
a cooler (30) applied to the laser-beam source unit (21), the cooler (30) being configured to cool the laser-beam source unit (21),
wherein the holding member (14) has a thermal conductivity higher than a thermal conductivity of the condenser lens (23), and contacts the cooler (30) across its entire surface.

2. The laser-beam emitting device (10) according to claim 1, wherein the cooler (30) comprises:
a heat-dissipating unit (31b, 32, 32Ce, 33, 64, 65, 66) configured to adjust an amount of heat dissipation; and
at least one temperature detector (61, 63) configured to detect a temperature of the heat-dissipating unit (31b, 32, 32Ce, 33, 64, 65, 66) and a laser output device (14, 15, 21, 23, 32) including the laser-beam source unit (21), the condenser lens (23), and the holding member (14),
wherein the heat-dissipating unit (31b, 32, 32Ce, 33, 64, 65, 66) adjusts the amount of heat dissipation according to the temperature detected by the at least one temperature detector (61, 63).

3. The laser-beam emitting device (10) according to claim 2, wherein
the heat-dissipating unit (31b, 32, 32Ce, 33, 64, 65, 66) includes a thermionic element (31), and
a temperature of a cooling surface (31a) of the thermionic element (31) is adjusted according to a temperature detected by the temperature detector (61, 63).

4. The laser-beam emitting device (10) according to claim 2, wherein
the heat-dissipating unit (31b, 32, 32Ce, 33, 64, 65, 66) includes an air-blowing mechanism (33), and
a volume of air of the air-blowing mechanism (33) is adjusted according to a temperature detected by the temperature detector (61, 63).

5. The laser-beam emitting device (10) according to claim 2, wherein
the heat-dissipating unit (31b, 32, 32Ce, 33, 64, 65, 66) includes a coolant channel (32Ce) through which a coolant passes, and
a temperature or flow rate of the coolant is adjusted according to a temperature detected by the temperature detector (61, 63).

6. The laser-beam emitting device (10) according to any one of claims 1 to 5, wherein
the condenser lens (23) is a planoconvex lens, and
a plane of the condenser lens (23) contacts the holding member (14) across its entire surface.

7. The laser-beam emitting device (10) according to any one of claims 1 to 6, wherein
the holding member (14) has a lens holding slot (16) to accept the condenser lens (23),
the condenser lens (23) has an outer surface (23c) that contacts an inner surface (16c) of the lens holding slot (16), and
the inner surface (16c) is larger than the outer surface (23c).

8. The laser-beam emitting device (10) according to any one of claims 1 to 7, wherein the holding member (14) has a heat transfer accelerator (27) at a portion where the holding member (14) contacts the condenser lens (23) and the cooler (30) across its entire surface.

9. The laser-beam emitting device (10) according to any one of claims 1 to 8, wherein the condenser lens (23) is provided with an antireflective coating film (23d) on a surface of the condenser lens (23).

10. The laser-beam emitting device (10) according to any one of claims 1 to 9, further comprising an exterior component (28) having a thermal conductivity lower than a thermal conductivity of the holding member (14) and encompassing the holding member (14).

11. The laser-beam emitting device (10) according to claim 10, wherein
the exterior component (28) includes a cooling slot (28c) exposing a part of the cooler (30) that contacts the holding member (14) across its entire surface, and
the cooling slot (28c) contacts an endothermic unit (15, 31a, 32a) of the cooler (30).

12. The laser-beam emitting device (10) according to any one of claims 1 to 11, wherein the laser-beam source unit (21) includes a laser array chip (21) on which a plurality of surface-emitting lasers are arranged.

13. The laser-beam emitting device (10) according to any one of claims 1 to 12, wherein
the cooler (30) includes a heat-dissipating member (32) configured to dissipate heat at a heat-dissipative part (31b, 32b), the heat being absorbed by an endothermic part (31a, 32a, 32Ba, 32Ca), and
the holding member (14) contacts the endothermic part (31a, 32a, 32Ba, 32Ca) across its entire surface.

14. The laser-beam emitting device (10) according to any one of claims 1 to 12, wherein the cooler (30) comprises:
a heat-dissipating member (32) configured to dissipate heat at a heat-dissipative part (31b, 32b), the heat being absorbed by an endothermic part (31a, 32a, 32Ba, 32Ca); and
a thermal diffusion member (15) on which the laser-beam source unit (21) is disposed, the thermal diffusion member (15) being applied to the endothermic part (31a, 32a, 32Ba, 32Ca), the thermal diffusion member (15) having a thermal conductivity equal to or greater than a thermal conductivity of the holding member (14),
wherein the holding member (14) contacts the thermal diffusion member (15) across its entire surface.

15. An engine spark plug system (40) comprising:
the laser-beam emitting device (10) according to any one of claims 1 to 14; and
a spark plug (52) configured to ignite an internal combustion engine (41) using a laser beam output from the laser-beam emitting device (10).
